# EUROPEAN PATENT SPECIFICATION

(11) **EP 4 059 911 B1**
(45) Date of publication and mention of the grant of the patent: **10.04.2024**
(21) Application number: 20887982.5
(22) Date of filing: 13.11.2020
(51) Int. Cl.: C04B 35/581, C04B 35/587, C04B 35/64, H05K 1/02, H05K 1/03, H05K 3/00, C04B 35/593, C04B 37/02, C04B 35/80

(54) **CERAMIC SUBSTRATE, COMPOSITE SUBSTRATE, CIRCUIT BOARD, METHOD FOR PRODUCING CERAMIC SUBSTRATE, METHOD FOR PRODUCING COMPOSITE SUBSTRATE, METHOD FOR PRODUCING CIRCUIT BOARD, AND METHOD FOR PRODUCING PLURALITY OF CIRCUIT BOARDS**
KERAMIKSUBSTRAT, VERBUNDSUBSTRAT, LEITERPLATTE, VERFAHREN ZUR HERSTELLUNG EINES KERAMISCHEN SUBSTRATS, VERFAHREN ZUR HERSTELLUNG EINES VERBUNDSUBSTRATS, VERFAHREN ZUR HERSTELLUNG EINER LEITERPLATTE UND VERFAHREN ZUR HERSTELLUNG VON MEHREREN LEITERPLATTEN
SUBSTRAT CÉRAMIQUE, SUBSTRAT COMPOSITE, CARTE DE CIRCUIT IMPRIMÉ, PROCÉDÉ DE PRODUCTION DE SUBSTRAT CÉRAMIQUE, PROCÉDÉ DE PRODUCTION DE SUBSTRAT COMPOSITE, PROCÉDÉ DE PRODUCTION DE CARTE DE CIRCUIT IMPRIMÉ, ET PROCÉDÉ POUR LA PRODUCTION D'UNE PLURALITÉ DE CARTES DE CIRCUIT IMPRIMÉ

(30) Priority: 15.11.2019 JP 2019206750
(43) Date of publication of application: 21.09.2022
(73) Proprietor: Denka Company Limited, Tokyo 103-8338 (JP)
(72) Inventor: TSUGAWA, Yuta, Tokyo 103-8338 (JP); NISHIMURA, Koji, Tokyo 103-8338 (JP); KOBASHI, Seiji, Tokyo 103-8338 (JP); ESHIMA, Yoshiyuki, Tokyo 103-8338 (JP); YUASA, Akimasa, Tokyo 103-8338 (JP)
(74) Representative: Gulde & Partner
(86) International application number: PCT/JP2020/042420
(87) International publication number: WO 2021/095843

(56) References cited:
- GB-A- 2 412 384
- JP-A- H02 141 476
- JP-A- H02 141 476
- JP-A- 2007 019 123
- JP-A- 2007 019 123
- JP-A- 2007 198 626
- JP-A- 2008 186 897
- JP-A- 2017 178 715
- US-A- 4 155 960
- US-A1- 2019 030 783

## Description

### TECHNICAL FIELD

The present invention relates to a ceramic substrate, a composite substrate, a circuit substrate, a manufacturing method of a ceramic substrate, a manufacturing method of a composite substrate, a manufacturing method of a circuit substrate, and a manufacturing method of a plurality of circuit substrates.

### BACKGROUND ART

For example, as in JP 2018-18971 A, it is known that metal layers are fixed to both surface sides of a ceramic substrate to produce a composite substrate and a circuit pattern is formed on one of the metal layers of the composite substrate to produce a circuit substrate. This circuit substrate is excellent from the viewpoint of high thermal conductivity and high insulating properties and thus used for, for example, power modules.

After that, such a ceramic substrate undergoes a metal layer-forming step of fixing the metal layers (for example, copper sheets) to both surface sides of the ceramic substrate, a circuit pattern-forming step of forming a circuit pattern on at least one of the metal layers, and a scribe line-forming step to be processed into a circuit substrate.

Further ceramic substrates are disclosed in JP H02-141476 A; JP 2017-178715 A, JP 2007-019123 A, US 2019/030783 A1, US 4155960 A and GB 2412384 A.

### SUMMARY OF THE INVENTION

### TECHNICAL PROBLEM

Incidentally, in recent years, a request for the flatness of circuit substrates has been intensifying more and more. In order to meet such a request, it is required to reduce the flatness of ceramic sheets that are used for bonding with metal sheets on a higher level.

An object of the present invention is to provide a ceramic substrate enabling the production of a circuit substrate having excellent flatness.

### SOLUTION TO PROBLEM

A ceramic substrate of the present invention is a ceramic substrate having a rectangular shape in a plan view, in which, in a first cut surface cut by a first straight line that passes through a center of the ceramic substrate and is parallel to any one side out of four sides in the plan view, a central portion in a length direction curves in a convex shape toward one side in a sheet thickness direction, in a second cut surface cut by a second straight line that passes through the center and is orthogonal to the first straight line, a central portion in a length direction curves in a convex shape toward the other side in the sheet thickness direction, and a value obtained by dividing a maximum projection amount in the sheet thickness direction of the ceramic substrate by a length of the diagonal line of the ceramic substrate is equal to or less than 6 pm/mm.

In the ceramic substrate of a preferred embodiment of the present invention , in first parallel cut surfaces, which are parallel to the first cut surface at individual locations extending to both ends of the ceramic substrate in a direction along the first straight line from the center, central portions of the ceramic substrate in the length direction curve in a convex shape toward the one side in the sheet thickness direction, and, in the first parallel cut surfaces at the individual locations, curvatures continuously decrease from the center to both ends of the ceramic substrate in a direction along the second straight line.

In the ceramic substrate of a preferred embodiment of the present invention, in second parallel cut surfaces, which are parallel to the second cut surface at individual locations extending to both ends of the ceramic substrate in a direction along the second straight line from the center, central portions of the ceramic substrate in the length direction curve in a convex shape toward the other side in the sheet thickness direction, and, in the second parallel cut surfaces at the individual locations, curvatures continuously increase from the center to both ends of the ceramic substrate in a direction along the first straight line.

In the ceramic substrate of a preferred embodiment of the present invention is the ceramic substrate having a three-dimensional shape that is linearly symmetrical with respect to the first straight line as a line of symmetry in the sheet thickness direction.

The ceramic substrate of a preferred embodiment of the present invention is the ceramic substrate having a three-dimensional shape that is linearly symmetrical with respect to the second straight line as a line of symmetry in the sheet thickness direction.

The ceramic substrate of a preferred embodiment of the present invention is the ceramic substrate containing silicon nitride or aluminum nitride.

A composite substrate of the present invention includes the ceramic substrate, a first metal layer fixed to a front surface side of the ceramic substrate, and a second metal layer fixed to a rear surface side of the ceramic substrate.

A circuit substrate of the present invention includes the ceramic substrate, a circuit pattern formed on one surface side of the ceramic substrate, and a metal layer fixed to the other surface side of the ceramic substrate.

A manufacturing method of a ceramic substrate of the present invention is a manufacturing method of the ceramic substrate including a strip-shaped green sheet-cutting step of cutting a strip-shaped green sheet containing a ceramic powder to obtain an individual green sheet, a sintering step of disposing the individual green sheet in a firing chamber, heating an inside of the firing chamber until a temperature in the firing chamber reaches at least equal to or higher than 1600°C, then, cooling the inside of the firing chamber, and sintering the individual green sheet to obtain the ceramic substrate, and a ceramic substrate-cutting step of cutting entire peripheral edges of the ceramic substrate cooled after the sintering step, wherein, the sintering step comprises a cooling region in which the temperature in the firing chamber is cooled at a cooling rate of 100 °C/hour or more, the cooling region includes a rapid cooling region in which the cooling rate is further increased when the temperature in the firing chamber is equal to or higher than 900°C and equal to or lower than 1200°C, and, in the ceramic substrate-cutting step, the entire peripheral edges are cut off at least 3 mm in width.

According to a preferred embodiment of the manufacturing method of the ceramic substrate, the ceramic powder contains silicon nitride powder or aluminum nitride powder.

A manufacturing method of a composite substrate of the present invention includes the manufacturing method of the ceramic substrate and a fixing step of fixing a first metal layer to a front surface side of the ceramic substrate and fixing a second metal layer to a rear surface side.

A manufacturing method of a circuit substrate of the present invention includes the manufacturing method of the composite substrate and a pattern-forming step of forming at least one circuit pattern on any one of the first metal layer and the second metal layer.

A manufacturing method of a plurality of circuit substrates of the present invention includes the manufacturing method of a composite substrate, a pattern-forming step of forming a plurality of circuit patterns on any one of the first metal layer and the second metal layer, and a dividing step of dividing the composite substrate on which the plurality of circuit patterns have been formed into a plurality of circuit substrates each having one circuit pattern.

### ADVANTAGEOUS EFFECTS OF INVENTION

According to the ceramic substrate of the present invention, a circuit substrate having excellent flatness can be produced.

### BRIEF DESCRIPTION OF THE DRAWINGS

Fig. 1 is a flow chart showing a manufacturing method of a plurality of mounting substrates of the present embodiment.
Fig. 2A is a flow chart of a green sheet-forming step included in the manufacturing method of a plurality of mounting substrates of the present embodiment.
Fig. 2B is a view for describing a molding step included in the green sheet-forming step of the present embodiment and a schematic view for describing a state where a strip-shaped green sheet is being produced from a slurry using a doctor blade molding device.
Fig. 2C is a view for describing a cutting step included in the green sheet-forming step of the present embodiment and a schematic view (side view) for describing a state where the strip-shaped green sheet is cut using a cutting device to produce an individual green sheet.
Fig. 2D is a schematic view of Fig. 2C viewed from the front side.
Fig. 3A is a view for describing a deposition step included in the green sheet-forming step of the present embodiment to a sintering step in the manufacturing method of a plurality of mounting substrates of the present embodiment.
Fig. 3B is a graph showing a profile of firing temperatures in the sintering step (also including conditions studied by a test).
Fig. 3C is a graph showing a relationship between rapid cooling start temperatures in a firing step (also including conditions studied by a test) and warpage amounts.
Fig. 3D is a plan view of a ceramic substrate of the present embodiment and a high/low distribution map with a high/low degree (concave condition) profile in a sheet thickness direction attached thereto.
Fig. 3E is a cross-sectional view of the ceramic substrate of Fig. 3D and a view in which a vertical cross-sectional view cut along an X₀-X₀ cutting line, a vertical cross-sectional view cut along an X₁-X₁ cutting line, and a vertical cross-sectional view cut along an X₂-X₂ cutting line are each arranged in an X direction.
Fig. 3F is a cross-sectional view of the ceramic substrate of Fig. 3D and a view in which a horizontal cross-sectional view cut along an Y₀-Y₀ cutting line, a horizontal cross-sectional view cut along an Y₁-Y₁ cutting line, and a horizontal cross-sectional view cut along an Y₂-Y₂ cutting line are each arranged in an Y direction.
Fig. 3G is a plan view of a ceramic substrate as a different example of the present embodiment and a high/low distribution map with a high/low degree (concave condition) profile in a sheet thickness direction attached thereto.
Fig. 4A is a schematic view for describing an outer peripheral portion-cutting step included in the manufacturing method of a plurality of mounting substrates of the present embodiment.
Fig. 4B is a graph showing a relationship between cut widths of the outer peripheral portion and warpage amounts in the outer peripheral portion-cutting step.
Fig. 5 is a view for describing a scribe line-forming step included in the manufacturing method of a plurality of mounting substrates of the present embodiment.
Fig. 6A is a view for describing a metal layer-forming step included in the manufacturing method of a plurality of mounting substrates of the present embodiment.
Fig. 6B is a cross-sectional view of the ceramic substrate of Fig. 6A and a horizontal cross-sectional view cut by a 6B-6B cutting line.
Fig. 7 is a view for describing a resist-printing step included in the manufacturing method of a plurality of mounting substrates of the present embodiment.
Fig. 8 is a view for describing an etching step included in the manufacturing method of a plurality of mounting substrates of the present embodiment.
Fig. 9 is a view for describing a dividing step included in the manufacturing method of a plurality of mounting substrates of the present embodiment.
Fig. 10 is a view for describing a metal layer-forming step of a modification example.

### DESCRIPTION OF EMBODIMENTS

### <<Overview>>

Hereinafter, the present embodiment will be described with reference to the drawings.

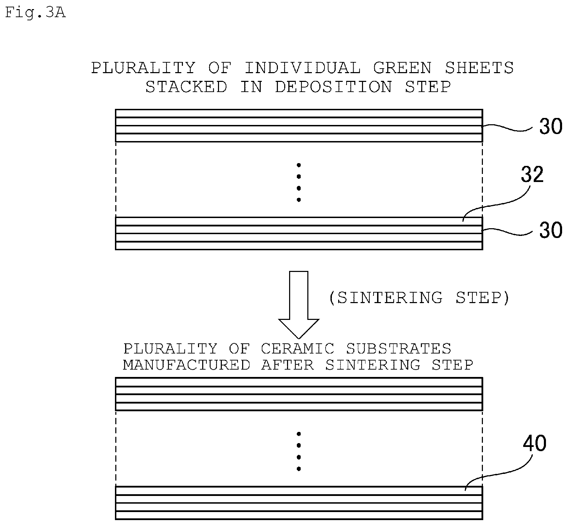

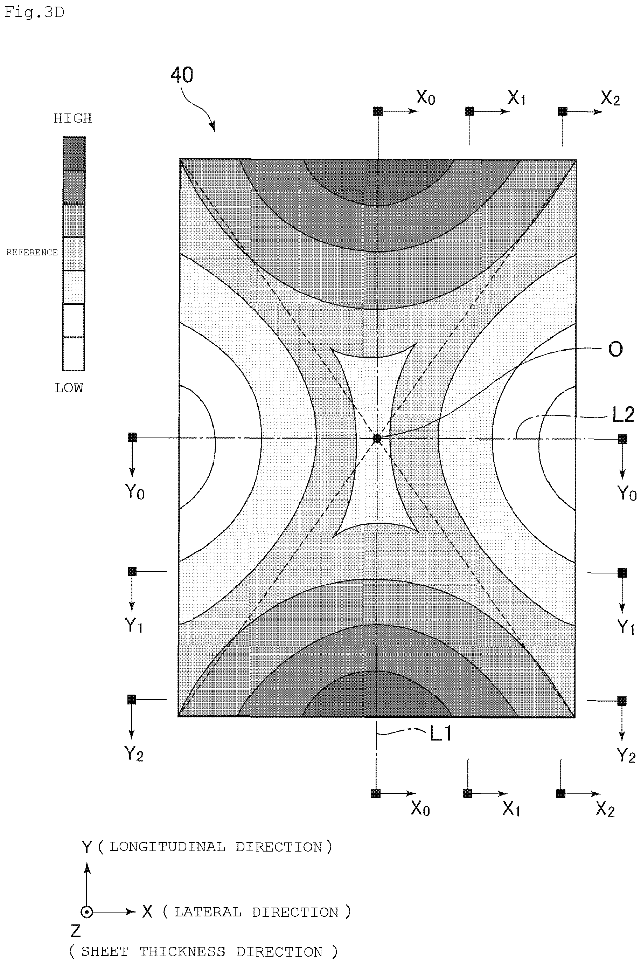

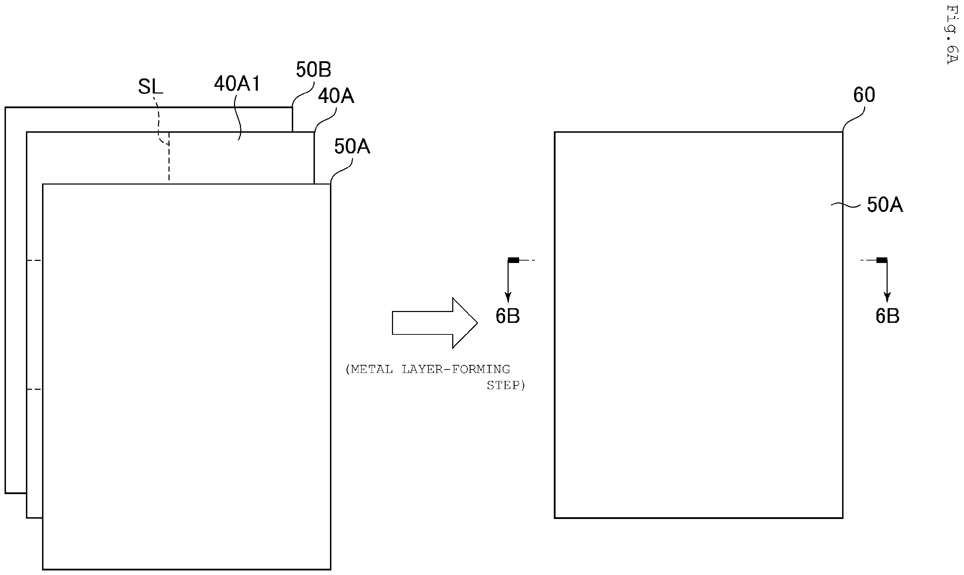

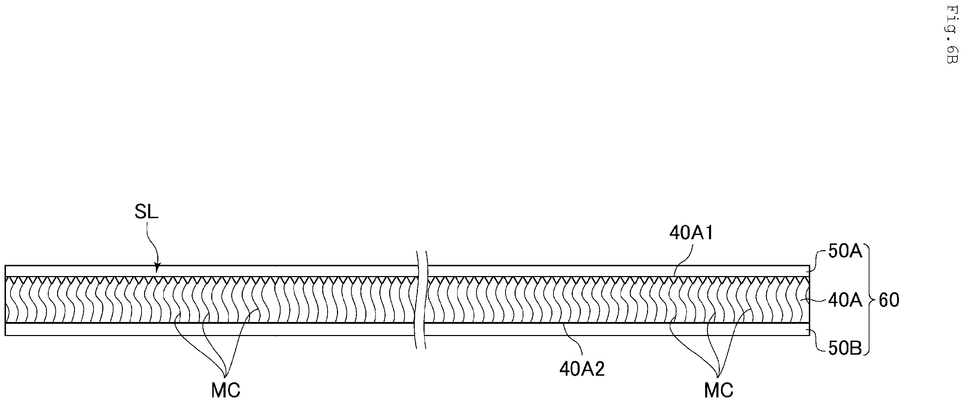

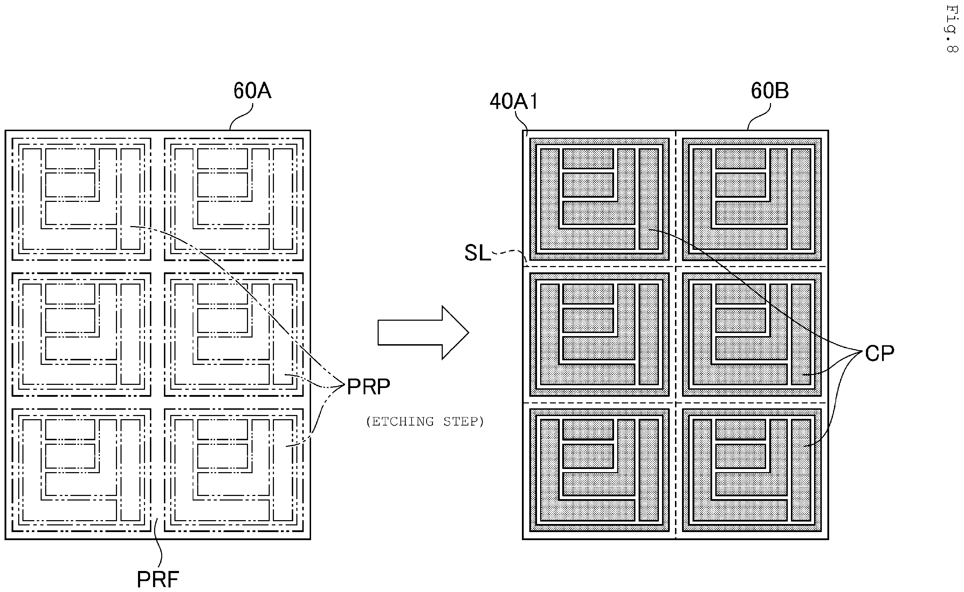

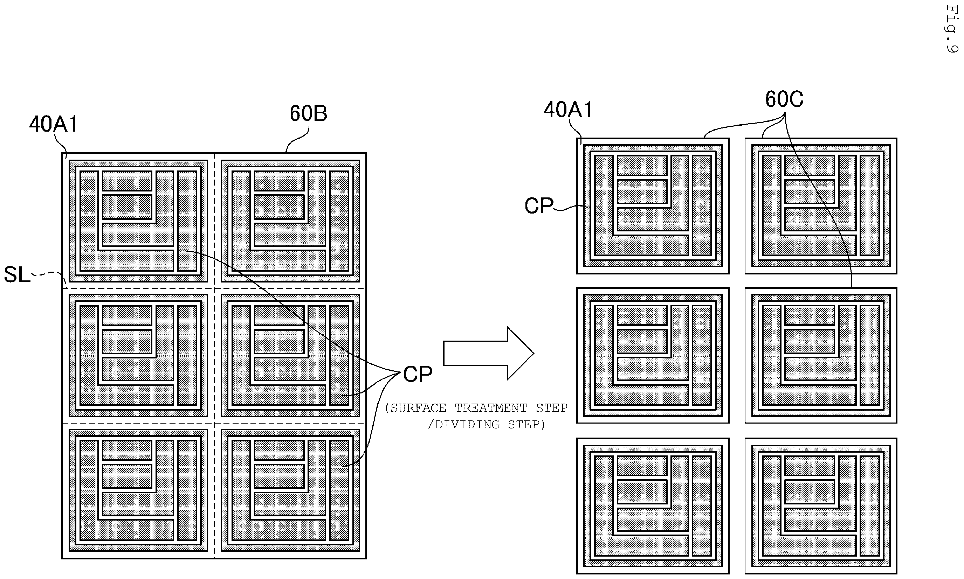

First, a ceramic substrate 40 (refer to Fig. 3A, Fig. 3D, and the like), a motherboard 60 (one example of a composite substrate, refer to Fig. 6A and Fig. 6B), an assembly substrate 60B (another example of the composite substrate, refer to Fig. 8 and Fig. 9), and a circuit substrate 60C (refer to Fig. 9) of the present embodiment will be described.

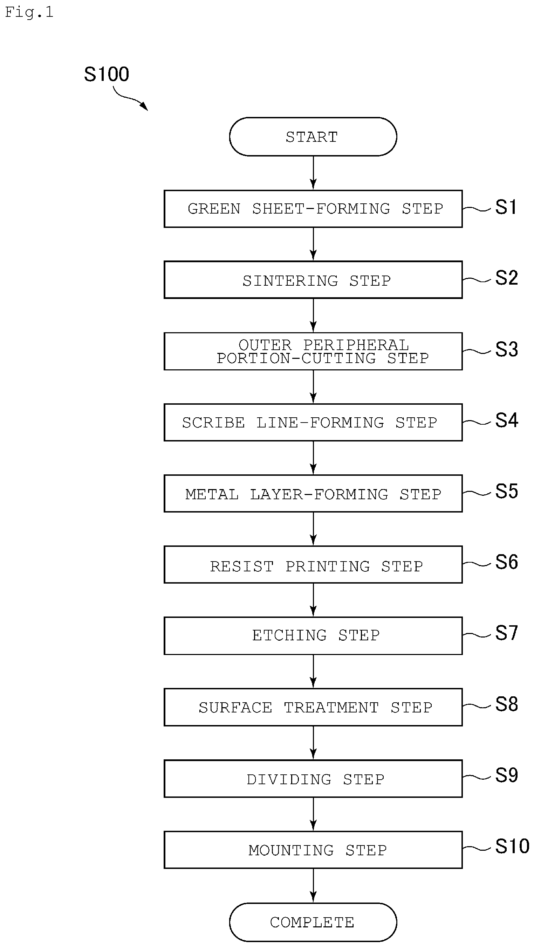

Next, a manufacturing method of a plurality of mounting substrates (not shown) of the present embodiment (refer to Fig. 1) will be described.

Next, the effect of the present embodiment will be described.

Next, a modification example of the present embodiment will be described.

In all of the drawings to be referred to in the following description, the same configuration elements will be given the same reference sign and will not be repeated.

### <<Ceramic substrate, motherboard, assembly substrate, and circuit substrate>>

First, the ceramic substrate 40 of the present embodiment will be described with reference to Fig. 3D to Fig. 3F.

The ceramic substrate 40 of the present embodiment has the following basic features.

The basic features of the ceramic substrate 40 of the present invention are that "the shape is rectangular in the plan view, in a first cut surface cut by a first straight line L1 that passes through the center and is parallel to any one side out of the four sides in the plan view, the central portion in the length direction curves in a convex shape toward one side in the sheet thickness direction, in a second cut surface cut by a second straight line L2 that passes through the center and is orthogonal to the first straight line L1, the central portion in the length direction curves in a convex shape toward the other side in the sheet thickness direction, and a value obtained by dividing the maximum projection amount in the sheet thickness direction of the ceramic substrate 40 by the length of the diagonal line of the ceramic substrate 40 is equal to or less than 6 pm/mm".

That is, the ceramic substrate 40 of the present embodiment is almost flat or completely flat.

In addition, the ceramic substrate 40 of the present embodiment may be one aspect as described below as long as the value obtained by dividing the maximum projection amount in the sheet thickness direction of the ceramic substrate 40 by the length of the diagonal line of the ceramic substrate 40 is equal to or less than 6 pm/mm, which is one of the above-described basic features.

For example, the ceramic substrate 40 of the present embodiment may further have a feature as follows: "in first parallel cut surfaces, which are parallel to the first cut surface at individual locations extending to both ends of the ceramic substrate 40 in a direction along the first straight line L1 from the center, central portions thereof in the length direction curve in a convex shape toward one side in the sheet thickness direction, and, in the first parallel cut surfaces at the individual locations, curvatures continuously increase from the center to both ends of the ceramic substrate 40 in a direction along the second straight line".

In addition, for example, the ceramic substrate 40 of the present embodiment may further have a feature as follows: "in second parallel cut surfaces, which are parallel to the second cut surface at individual locations extending to both ends of the ceramic substrate 40 in a direction along the second straight line L2 from the center, central portions thereof in the length direction curve in a convex shape toward the other side in the sheet thickness direction, and, in the second parallel cut surfaces at the individual locations, curvatures continuously decrease from the center to both ends of the ceramic substrate 40 in a direction along the first straight line".

In addition, for example, the ceramic substrate 40 of the present embodiment may further have a feature of "having a three-dimensional shape that is linearly symmetrical with respect to the first straight line L1 as a line of symmetry in the sheet thickness direction".

In addition, for example, the ceramic substrate 40 of the present embodiment may further have a feature of "having a three-dimensional shape that is linearly symmetrical with respect to the second straight line L2 as a line of symmetry in the sheet thickness direction".

Next, a specific configuration of the ceramic substrate 40 of the present embodiment will be described.

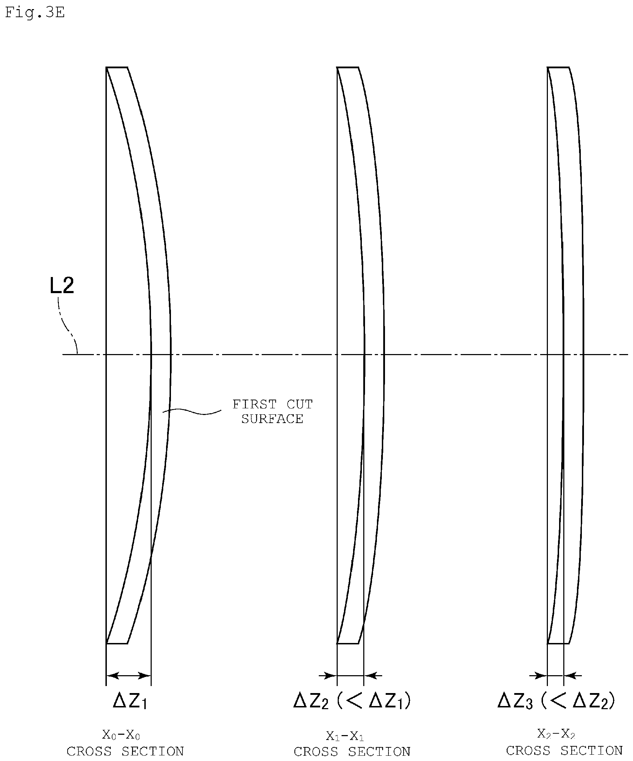

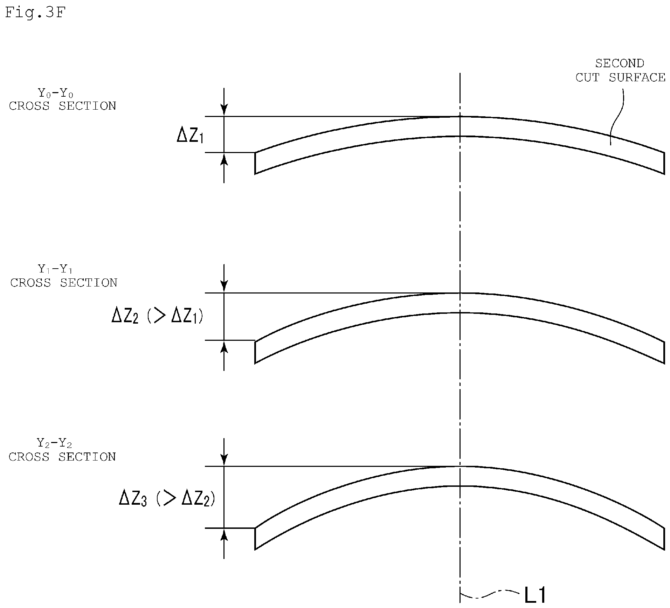

Fig. 3D is a plan view of the ceramic substrate 40 of the present embodiment and a high/low distribution map with a high/low degree (concave condition) profile in the sheet thickness direction (Z direction) attached thereto. Fig. 3E is a cross-sectional view (end face view) of the ceramic substrate 40 of Fig. 3D and a view in which a vertical cross-sectional view cut along an X₀-X₀ cutting line (X₀-X₀ cross section), a vertical cross-sectional view cut along an X₁-X₁ cutting line (X₁-X₁ cross section), and a vertical cross-sectional view cut along an X₂-X₂ cutting line (X₂-X₂ cross section) are each arranged in an X direction. Fig. 3F is a cross-sectional view of the ceramic substrate 40 of Fig. 3D and a view in which a horizontal cross-sectional view cut along an Y₀-Y₀ cutting line, a horizontal cross-sectional view cut along an Y₁-Y₁ cutting line, and a horizontal cross-sectional view cut along an Y₂-Y₂ cutting line are each arranged in an Y direction.

As shown in Fig. 3D to Fig. 3F, the ceramic substrate 40 is not flat in the sheet thickness direction, but is warped. A specific warped state can be represented by configurations as described below (first configuration to fourth configuration).

### [First configuration]

In the first configuration, in a case where an intersection O formed by the pair of diagonal lines (broken lines in Fig. 3D) of a plan view is regarded as a reference in the sheet thickness direction of the ceramic substrate 40, out of the four regions divided by the pair of diagonal lines, one pair of a pair of first regions facing each other across the intersection and a pair of second regions facing each other across the intersection O is located on one side in the sheet thickness direction with respect to the intersection O, and the other pair is located on the other side in the sheet thickness direction with respect to the intersection O.

In addition, the warpage amount is equal to or less than 6 pm/mm. Here, the warpage amount in the present specification refers to a value obtained by dividing the maximum projection amount in the sheet thickness direction of the ceramic substrate 40 by the length of the diagonal line of the ceramic substrate 40. As an example, the ceramic substrate 40 of the present embodiment has a length of 206 mm and a width of 146 mm, and thus the length of the diagonal line is about 252.5 mm.

Here, as shown in Fig. 3E, in a cut surface cut by the straight line L1 in the Y direction that passes through a center O (first straight line L1) (first cut surface), the portion of the center O forms an arc shape that is convex toward one side in the sheet thickness direction. In other words, the first cut surface forms an arc-shaped surface that is convex toward one side in the sheet thickness direction with an inflection point at the location of the portion of the center O. In still other words, the first cut surface forms an arc-shaped surface that is convex toward one side in the sheet thickness direction with the portion of the center O located at the farthest location toward one direction in the sheet thickness direction. The projection amount of the portion that becomes a convex shape in the portion of the center O in this case (the amount of a portion that becomes a convex shape or a concave shape compared with a case where the portion is flat (the reference in the drawing)) is defined as ΔZ₁. In addition, the projection amount decreases to be ΔZ₂ (< ΔZ₁) and ΔZ₃ (< ΔZ₂) toward an end portion in a width direction throughout from the center O to the end portion. Here, the projection amount ΔZ₁ is about 600 um as an example.

In the case of the example shown in Fig. 3E, the arc-shaped surface that becomes a convex shape toward one side in the sheet thickness direction forms an almost symmetrical shape with respect to the straight line L2 in the X direction that passes through the center O (second straight line L2); however, for example, in a case where the arc-shaped surface forms an asymmetrical shape with respect to the straight line L2, the projection amount is the amount of a portion that becomes a convex shape or a concave shape compared with a case where the portion is flat (the reference in the drawing).

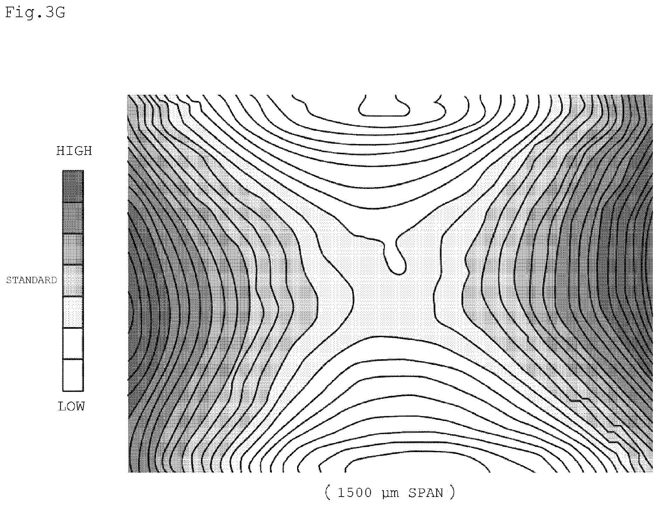

In addition, the "maximum projection amount" in the present specification means the maximum value of the amounts of portions that becomes a convex shape or a concave shape compared with a case where the portions are flat. Therefore, in the case of an asymmetrical shape with respect to one or both of the width direction and the length direction as in the example of Fig. 3G, there may be a case where a portion that becomes the maximum projection amount is offset from central lines in one or both of the width direction and the length direction.

Here, in the present embodiment, the warpage amount of the ceramic substrate 40 was measured as described below. That is, a laser beam was radiated from to a laser three-dimensional shape measuring instrument to the ceramic substrate 40, light diffused and reflected from the ceramic substrate 40 was received to calculate the displacement amount, and the warpage amount of the main surface of the ceramic substrate 40 was measured. Here, the laser three-dimensional shape measuring instrument adopts K2-300 (manufactured by Kohzu Precision Co., Ltd.) as an XYθ stage unit, LK-G500 (manufactured by Keyence Corporation) as a highprecision laser displacement meter, and SC-200K (manufactured by Kohzu Precision Co., Ltd.) as a motor controller, and DL-100 (manufactured by Kohzu Precision Co., Ltd.) as an AD converter. In this case, the measurement pitches were set to 1.0 mm.

The "maximum projection amount" in the present embodiment corresponds to a difference between the maximum value and the minimum value of displacement measured with the laser three-dimensional shape measuring instrument.

Here, as shown in Fig. 3F, in a cut surface cut by the straight line L2 in the X direction that passes through the center O (second straight line L2) (second cut surface), the portion of the center O forms an arc shape that is convex toward the other side in the sheet thickness direction. In other words, the second cut surface forms an arc-shaped surface that is convex toward the other side in the sheet thickness direction with an inflection point at the location of the portion of the center O. In still other words, the second cut surface forms an arc-shaped surface that is convex toward the other side in the sheet thickness direction with the portion of the center O located at the farthest location toward the other direction in the sheet thickness direction. The projection amount of the portion that becomes a convex shape in the portion of the center O in this case (the amount of a portion that becomes a convex shape or a concave shape compared with a case where the portion is flat) is defined as ΔZ₁. In addition, the projection amount increases to be ΔZ₂ (> ΔZ₁) and AZ₃ (> ΔZ₂) toward an end portion in a width direction throughout from the center O to the end portion. Here, the projection amount ΔZ₁ is about 400 um as an example.

The ceramic substrate 40 of the present embodiment forms a warpage state that is linearly symmetrical with respect to the straight line L1 and the straight line L2 to be described below. That is, the ceramic substrate 40 of the present embodiment has a three-dimensional shape that is linearly symmetrical with respect to the straight line L1 and the straight line L2.

Based on what has been described above, in the ceramic substrate 40 of the present embodiment, since the maximum projection amount is about 600 um and the length of the diagonal line is about 252.5 mm, the warpage amount becomes about 2.37 pm/mm, which satisfies 2 pm/mm to equal to or less than 6 pm/mm.

### [Second configuration]

The second configuration is a configuration that is the first configuration viewed from another viewpoint.

In the second configuration, in the first cut surface cut by the first straight line L1 that passes through the center O and is parallel to any one side out of the four sides in the plan view of the ceramic substrate 40, the central portion in the length direction (Y direction) curves in a convex shape toward one side in the sheet thickness direction (refer to Fig. 3E). In addition, in the second cut surface cut by the second straight line L2 that passes through the center O and is orthogonal to the straight line L1, the central portion in the length direction curves in a convex shape toward the other side in the sheet thickness direction (refer to Fig. 3F), and the warpage amount is equal to or less than 6 pm/mm.

### [Third configuration]

The third configuration is a configuration for which the second configuration is presumed.

In the third configuration, in first parallel cut surfaces, which are parallel to the first cut surface (X₀-X₀ cross section) at individual locations extending to both ends of the ceramic substrate 40 in the direction along the straight line L1 from the center O (Y direction) (the X₁-X₁ cross section and the X₂-X₂ cross section in Fig, 3E), the central portions thereof in the length direction curve in a convex shape toward one side in the sheet thickness direction, and, in the first parallel cut surfaces at the individual locations, the curvatures continuously decrease from the center O to both ends of the ceramic substrate 40 in the direction along the straight line L2 (X direction) (refer to Fig. 3E).

### [Fourth configuration]

The fourth configuration is a configuration for which the second configuration is presumed.

In the fourth configuration, in second parallel cut surfaces, which are parallel to the second cut surface at individual locations extending to both ends of the ceramic substrate 40 in the direction along the straight line L2 from the center O (X direction) (the Y₁-Y₁ cross section and the Y₂-Y₂ cross section in Fig, 3F), the central portions thereof in the length direction curve in a convex shape toward the other side in the sheet thickness direction, and, in the second parallel cut surfaces at the individual locations, the curvatures continuously increase from the center O to both ends of the ceramic substrate 40 in the direction along the straight line L1 (Y direction) (refer to Fig. 3F).

Hitherto, the individual configurations of the ceramic substrate 40 have been described. In addition, the ceramic substrate 40 has these configurations and thereby configures a substrate having a so-called saddle-like shape in which the center O becomes a saddle point.

Next, the motherboard 60 of the present embodiment will be described with reference to Fig. 6A and Fig. 6B. The motherboard 60 of the present embodiment includes the ceramic substrate 40, a first metal layer 50A fixed to a front surface 40A1 side of the ceramic substrate 40, and a second metal layer 50B fixed to a rear surface 40A2 side of the ceramic substrate 40.

Next, the circuit substrate 60C of the present embodiment will be described with reference to Fig. 9. The circuit substrate 60C of the present embodiment includes the ceramic substrate 40, a circuit pattern CP formed on one surface side of the ceramic substrate 40 (in the present embodiment, on the front surface 40A1 side as an example), and a metal layer fixed to the other surface side (in the present embodiment, to the rear surface 40A2 side (refer to Fig. 6B) as an example) of the ceramic substrate 40 (the second metal layer 50B).

As shown in Fig. 8 and Fig. 9, the assembly substrate 60B of the present embodiment is an assembly of a plurality of the circuit substrates 60C in which the plurality of circuit substrates 60C are arranged side by side.

Hitherto, the ceramic substrate 40, the motherboard 60, the assembly substrate 60B, and the circuit substrate 60C of the present embodiment have been described.

### <<Manufacturing method of plurality of mounting substrates of present embodiment>>

Next, a manufacturing method S100 of a plurality of mounting substrates of the present embodiment (hereinafter, referred to as the manufacturing method S100 of the present embodiment) will be described with reference to Fig. 1 and the like.

The manufacturing method S100 of the present embodiment includes a green sheet-forming step S1, a sintering step S2, an outer peripheral portion-cutting step S3, a scribe line-forming step S4 (hereinafter, referred to as SL forming step S4), and a metal layer-forming step S5, a resist printing step S6, an etching step S7, a surface treatment step S8, a dividing step S9, and a mounting step S10. In addition, in the manufacturing method S100 of the present embodiment, the individual steps are performed in the described order.

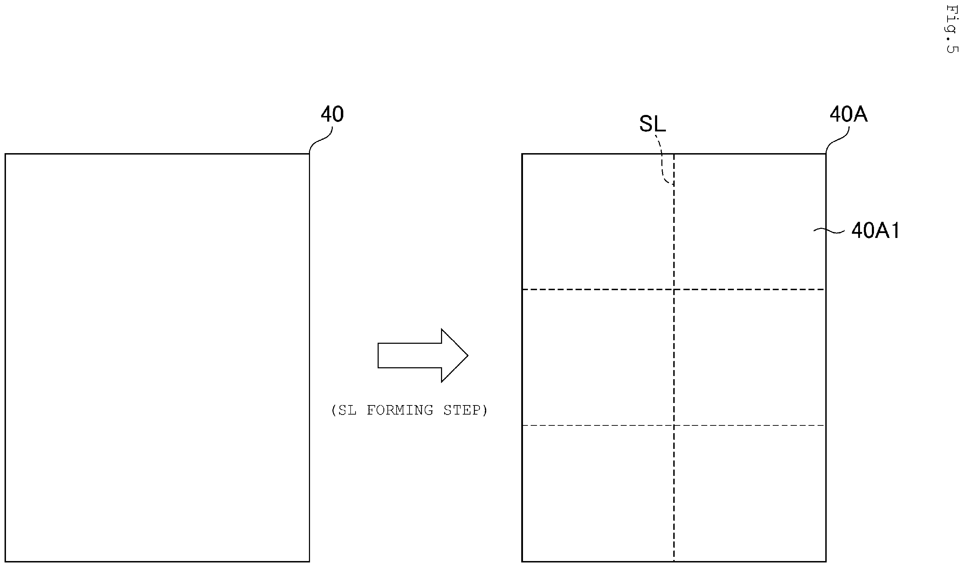

The relationships between the times where the individual steps are completed in the manufacturing method S100 of the present embodiment and products at those times are as described below.
Each step upon completion product at that time
Sintering step S2 Ceramic substrate 40 (refer to Fig. 3D)
SL forming step S4 SL-drawn ceramic substrate 40A (refer to Fig. 5)
Metal layer-forming step S5 Motherboard 60 (refer to Fig. 6A and Fig. 6B)
Etching step S7 Assembly substrate 60B (refer to Fig. 8)
Dividing step S9 Plurality of circuit substrates 60C (refer to Fig. 9)
Mounting step S10 Plurality of mounting substrates

In addition, the description of each step of the manufacturing method S100 of the present embodiment includes the description of each of the following inventions.

### (Invention relating to a manufacturing method of ceramic substrate)

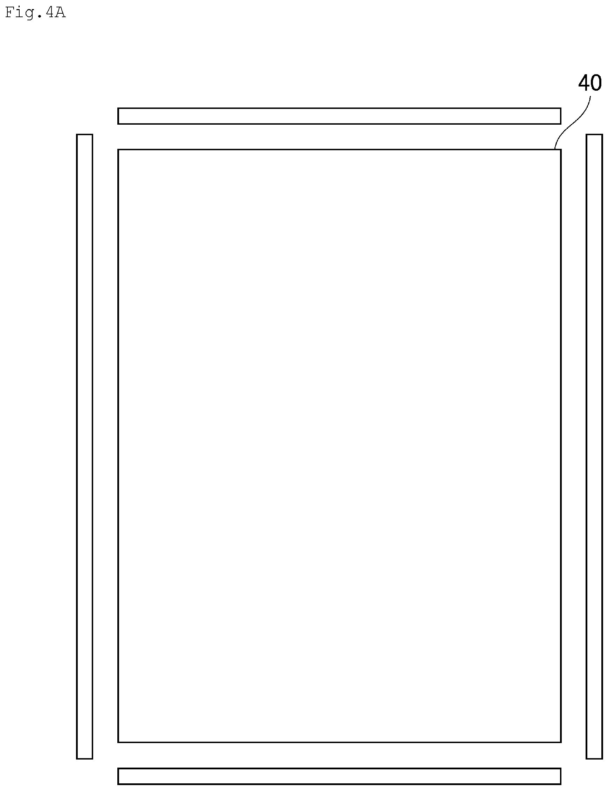

A manufacturing method of the ceramic substrate 40 of the present embodiment includes a strip-shaped green sheet-cutting step of cutting a strip-shaped green sheet 20 containing a ceramic powder to obtain an individual green sheet 30, a sintering step of disposing the individual green sheet 30 in a firing chamber, heating the inside of the firing chamber until the temperature in the firing chamber reaches at least equal to or higher than 1600°C, then, cooling the inside of the firing chamber, and sintering the individual green sheet 30 to obtain the ceramic substrate 40, and a ceramic substrate-cutting step of cutting the entire peripheral edges of the ceramic substrate cooled after the sintering step, in the sintering step, the temperature in the firing chamber is rapidly cooled when the temperature in the firing chamber is a temperature of equal to or higher than 900°C and equal to or lower than 1200°C during the cooling of the inside of the firing chamber (refer to Fig. 1, Fig. 2B, Fig. 2C, Fig. 3B, and the like), and, in the ceramic substrate-cutting step, the entire peripheral edges are cut off at least 3 mm in width (refer to Fig. 1 and Fig. 4A).

(Invention relating to manufacturing method of motherboard)

A manufacturing method of the motherboard 60 of the present embodiment includes the manufacturing method of the ceramic substrate and a fixing step of fixing the first metal layer 50A to the front surface 40A1 side of the ceramic substrate 40 and fixing the second metal layer 50B to the rear surface 40A2 side (refer to Fig. 6A).

### (Invention relating to manufacturing method of circuit substrate)

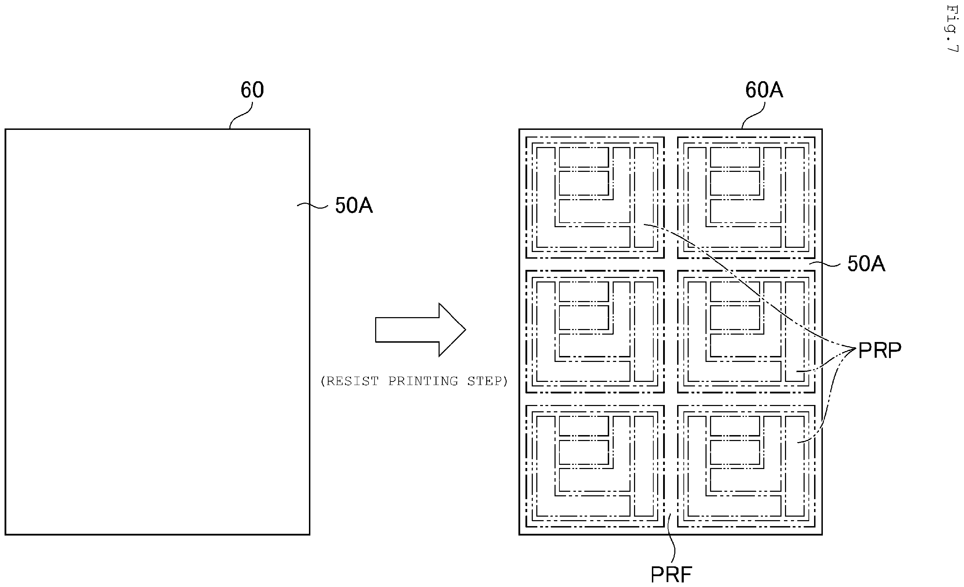

A manufacturing method of the circuit substrate 60C of the present embodiment includes the manufacturing method of the motherboard 60 and a pattern-forming step of forming at least one circuit pattern CP on at least one of the first metal layer 50A and the second metal layer 50B (in the case of the present embodiment, the first metal layer 50A as an example) (refer to Fig. 7, Fig. 8, and the like).

### (Manufacturing method of plurality of circuit substrates)

A manufacturing method of a plurality of the circuit substrates 60C of the present embodiment includes the manufacturing method of the motherboard 60, a pattern-forming step of forming a plurality of circuit patterns CP on any one of the first metal layer 50A and the second metal layer 50B (in the case of the present embodiment, the first metal layer 50A as an example), and a dividing step of dividing the motherboard 60 on which the plurality of circuit patterns CP have been formed into a plurality of the circuit substrates 60C each including one circuit pattern CP (refer to Fig. 7 to Fig. 9 and the like).

Hereinafter, each step will be described.

### <Green sheet-forming step and sintering step>

A step of performing a green sheet-forming step S1 and a sintering step S2 in the present embodiment in combination in the described order corresponds to the manufacturing method of the ceramic substrate 40.

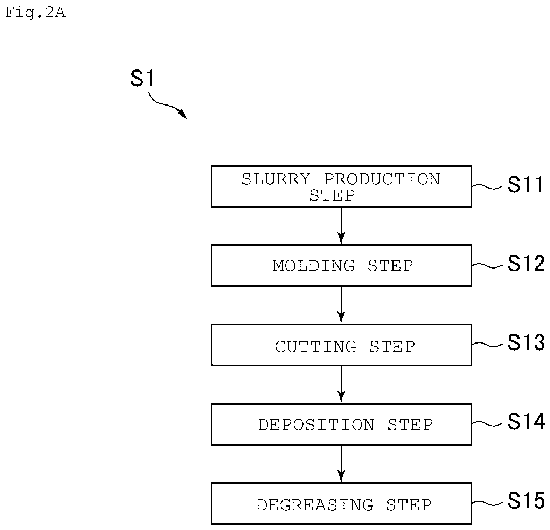

Hereinafter, the manufacturing method of the ceramic substrate 40 of the present embodiment will be described with reference to Fig. 2A to Fig. 2D, Fig. 3A to Fig. 3F, and Fig. 4A and Fig. 4B.

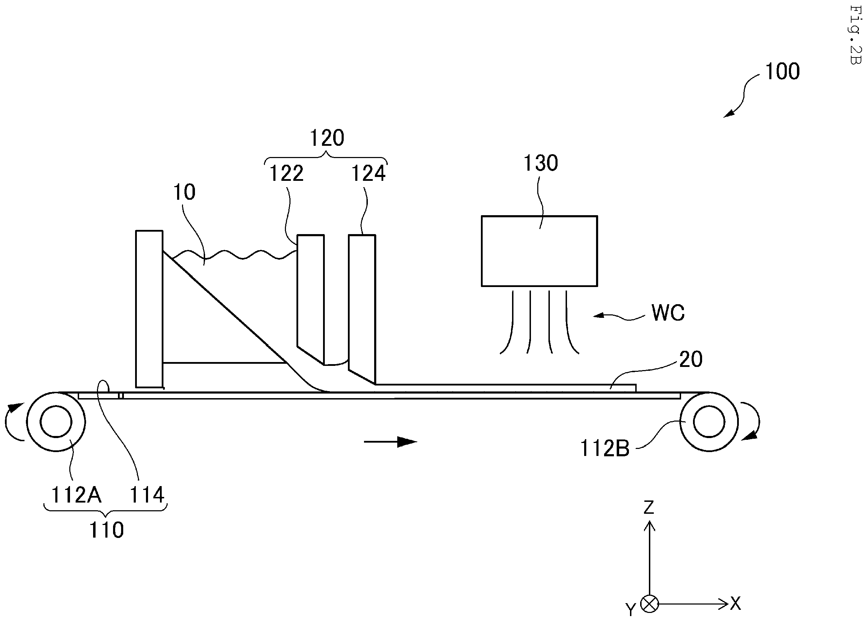

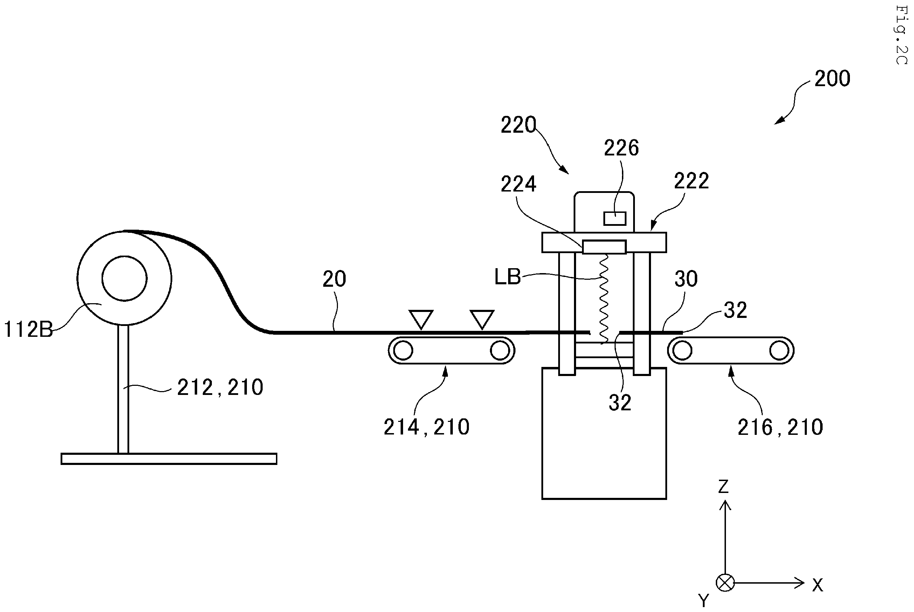

Here, the ceramic substrate 40 is, as an example, a ceramic substrate including a circuit substrate for a power module or a mounting substrate that is mounted in electric vehicles, railroad vehicles, and other industrial equipment. As an example, the ceramic substrate 40 is obtained by sintering the individual green sheets 30 (refer to Fig. 2C) to be described below in a laminated state (refer to Fig. 3A). In addition, the individual green sheets 30 are obtained by cutting the strip-shaped green sheet 20 (refer to Fig. 2B and Fig. 2C). That is, the relationship between the ceramic substrate 40 and the individual green sheet 30 has a relationship between a finished article and an intermediate article (an article manufactured by the steps before the finished article is produced) or a relationship between a first intermediate article and a second intermediate article (an article manufactured by the steps before the first intermediate article is produced). Therefore, the individual green sheet 30 of the present embodiment is manufactured by the steps up to an intermediate stage of the manufacturing method of the ceramic substrate 40 of the present embodiment.

The ceramic substrate 40 of the present embodiment is, as an example, a rectangular sheet (refer to Fig. 3D, Fig. 5, and the like).

### <Green sheet-forming step>

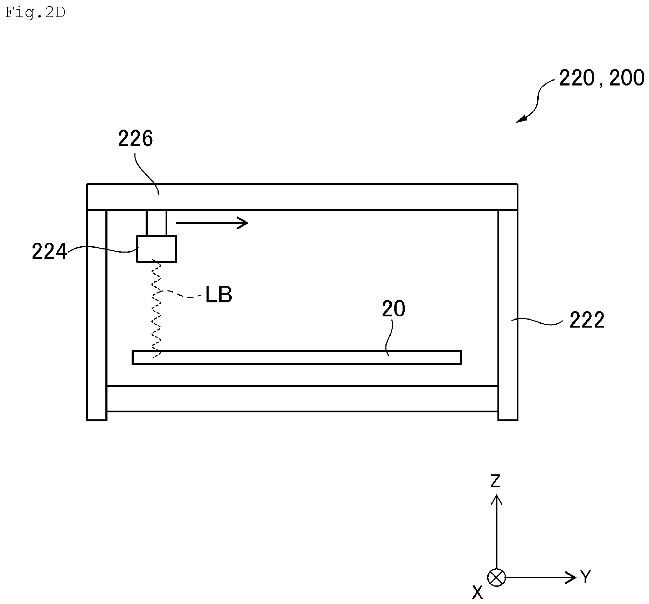

Hereinafter, the green sheet-forming step S1 will be described with reference to Fig. 2A, Fig. 2B, Fig. 2C, and Fig. 2D. The green sheet-forming step S1 of the present embodiment includes a slurry production step S11, a molding step S12, a cutting step S13, a deposition step S14, and a degreasing step S15 and is performed in the described order (refer to Fig. 1 and Fig. 2A).

### [Slurry production step]

The slurry production step S11 will be described. The present step is a step of mixing a raw material powder to be described below and an organic solvent to prepare a slurry 10. The slurry 10 produced in the present step (refer to Fig. 2B) is molded into a strip-shaped green sheet 20 in the next step (molding step S12).

The raw material powder for the slurry 10 is a powder containing a main component to be described below and a sintering aid. The main component is, as an example, 80% by weight to 98.3% by mass of silicon nitride (Si₃N₄), and the sintering aid is, as an example, 1% by weight to 10% by mass (oxide equivalent) of at least one rare earth element and 0.7% by weight to 10% by mass (oxide equivalent) of magnesium (Mg). The gelatinization rate of a silicon nitride powder is preferably 20% to 100% in consideration of the density, bending strength, and thermal conductivity of the ceramic substrate 40.

Here, as the supplementation of the meaning of "to" used in the present specification, for example, "20% to 100%" means "equal to or more than 20% and equal to or less than 100%". In addition, "-" used in the present specification means "equal to or more than a part described before "to" and equal to or less than a part described after "to".

The reason for setting the proportion of silicon nitride (Si₃N₄) in the raw material powder to 80% by weight to 98.3% by mass as an example is that the bending strength and thermal conductivity of the ceramic substrate 40 to be obtained are not too low, the compactness of the ceramic substrate 40 due to the lack of the sintering aid is ensured, and the like.

Hereinafter, for the sake of simplification of the description, the raw material powder of silicon nitride will be referred to as Si₃N₄ powder (also known as silicon nitride powder and an example of a ceramic powder), the raw material powder of Mg will be referred to as MgO powder, and the powder of rare earth element raw material will be referred to as Y₂O₃ powder. Here, the raw material powder of silicon nitride and the raw material powders of the sintering aid may not be Si₃N₄ powder, MgO powder, and Y₂O₃ powder, respectively.

In addition, the Si₃N₄ powder, the MgO powder, and the Y₂O₃ powder blended as described above are mixed with a plasticizer, an organic binder, and an organic solvent to produce the slurry 10. Therefore, the slurry 10 that is produced in the present step contains the ceramic powder.

Hitherto, the slurry production step S11 has been described.

### [Molding step]

Next, the molding step S12 will be described. As shown in Fig. 2B, the present step is a step of manufacturing the strip-shaped green sheet 20 from the slurry 10.

The present step is performed using, as an example, a doctor blade molding device 100 shown in Fig. 2B. Here, the doctor blade molding device 100 includes a belt transport mechanism 110, a molding unit 120, and a heating unit 130. The belt transport mechanism 110 has an upstream roller 112A, a downstream roller 112B, and a belt 114 and drives the downstream roller 112 to move the belt 114 from the upstream roller 112 to the downstream roller 112 (along the X direction). The molding unit 120 is disposed on the upper side of the belt 114 (on the Z direction side of the belt 114) and faces the belt 114. The molding unit 120 has an accommodation portion 122 that accommodates the slurry 10 and a doctor blade 124.

In addition, the molding unit 120 regulates the slurry 10 that is taken out from the accommodation portion 122 due to its own weight and an adhesive force to the moving belt 114 with the doctor blade 124 to provide the slurry 10 with a sheet shape having a give film thickness as shown in Fig. 2B. The heating unit 130 blows warm air WC to the slurry 10 having a given film thickness on the belt 114 to make the slurry 10 into a sheet (vaporize the organic solvent). As a result, in the molding step S12, a strip-shaped green sheet 20 having a given width (the Y direction in the drawing corresponds to the width direction) is produced from the slurry 10. That is, in the molding step S12, the slurry 10 is made into a strip shape by doctor blade molding to obtain a strip-shaped green sheet 20 containing Si₃N₄ (ceramic) as an example.

As an example, the present step is performed after the slurry 10 produced in the slurry production step S11 is defoamed and the slurry 10 is thickened. In addition, the film thickness of the strip-shaped green sheet 20 produced in the present step is set in consideration of the film thickness of the ceramic substrate 40 that is manufactured in the end. Accordingly, the regulation conditions (the separation distance from the belt 114 and the like) of the doctor blade 124 for regulating the slurry 10 to a given film thickness are also set in consideration of the film thickness of the ceramic substrate 40 that is manufactured in the end.

Hitherto, the molding step S12 has been described.

### [Cutting step]

Next, the cutting step S13 of the strip-shaped green sheet 20 will be described. As shown in Fig. 2C, the present step is a step of cutting the strip-shaped green sheet 20 to manufacture the individual green sheet 30.

The present step is performed using a cutting device 200 shown in Fig. 2C as an example. Here, the cutting device 200 includes a sheet transport mechanism 210 and a cutting portion 220.

The sheet transport mechanism 210 has a support portion 212, a first transport portion 214, and a second transport portion 216. The support portion 212 supports the roller 112B having the strip-shaped green sheet 20 produced in the molding step S12 wound around the outer peripheral surface (refer to Fig. 2B and Fig. 2C) so as to be capable of rotating. The first transport portion 214 adjusts the posture of the strip-shaped green sheet 20 transported from the support portion 212 and transports the strip-shaped green sheet 20 to the cutting portion 220 along the X direction (along the longitudinal direction of the strip-shaped green sheet 20). The second transport portion 216 further transports the individual green sheet 30 produced by cutting the strip-shaped green sheet 20 with the cutting portion 220 downstream (in the X direction).

In addition, the cutting portion 220 has a housing 222, a radiation portion 224, and a moving mechanism 226. The radiation portion 224 radiates a laser beam LB as an example. The moving mechanism 226 causes the radiation portion 224 to scan the strip-shaped green sheet 20 from one end to the other end in the lateral direction (Y direction in the drawing). The radiation portion 224 and the moving mechanism 226 are attached to the housing 222.

In addition, in the cutting device 200 of the present embodiment, the strip-shaped green sheet 20 is transported with the sheet transport mechanism 210 by the length of the individual green sheet 30, the strip-shaped green sheet 20 is stopped, and the strip-shaped green sheet 20 is cut with the cutting portion 220. In this case, the cutting portion 220 causes the radiation portion 224 to radiate the laser beam LB while moving the radiation portion 224 with the moving mechanism 226 along the Y direction from one end side to the other end side in the lateral direction of the strip-shaped green sheet 20 (refer to Fig. 2D). In addition, the radiation portion 224 that is scanned with the moving mechanism 226 intermittently radiates the laser beam LB. Here, "intermittently" means repetition of radiating for a certain period of time and not radiating for a certain period of time. Therefore, the moving mechanism 226 causes the radiation portion 224 to scan by causing the radiation portion 224 to repeatedly move and stop (refer to Fig. 2D).

In the present step, the laser beam LB is radiated to the strip-shaped green sheet 20 as described above, thereby cutting the strip-shaped green sheet 20 to obtain the individual green sheet 30. The laser beam LB may be a carbon dioxide laser beam, an infrared laser beam, an ultraviolet laser beam or other laser beams as long as the strip-shaped green sheet 20 can be cut. In addition, in the description of the present step, the strip-shaped green sheet 20 is cut using the cutting device 200 shown in Fig. 2C to manufacture the individual green sheet 30 as an example, but other methods may also be used as long as the individual green sheet 30 can be manufactured from the strip-shaped green sheet 20. For example, the individual green sheet 30 may be manufactured by blanking the strip-shaped green sheet 20 by pressing using a pressing device (not shown).

The ceramic substrate 40 according to the present embodiment is preferably rectangular. In addition, the length of the diagonal line on the front surface of the ceramic substrate 40 is preferably equal to or more than 150 mm, more preferably equal to or more than 200 mm, and particularly preferably equal to or more than 236 mm. The upper limit is not particularly limited and can be set to, for example, equal to or less than 254 mm.

The thickness of the ceramic substrate 40 according to the present embodiment can be set to equal to or more than 0.1 mm and equal to or less than 3.0 mm and is preferably equal to or more than 0.2 mm and equal to or less than 1.2 mm and more preferably equal to or more than 0.25 mm and equal to or less than 0.5 mm.

Hitherto, the cutting step S13 of the strip-shaped green sheet 20 has been described.

### [Deposition step]

Next, the deposition step S14 will be described. As shown in Fig. 3A, the present step is a step of stacking a plurality of the individual green sheets 30 in the thickness direction. The present step is a step for efficiently sintering the individual green sheets 30 in the subsequent step (sintering step S2).

In the present step, as shown in Fig. 3A, the plurality of individual green sheets 30 are deposited with a non-reactive powder layer (not shown) to be described below interposed therebetween. Here, when the number of the individual green sheets 30 to be stacked is small, the number of the sheets that can be treated at one time in a sintering furnace (not shown) in the subsequent sintering step S2 becomes small (the production efficiency becomes low). On the other hand, when the number of the individual green sheets 30 to be stacked is large, it becomes difficult for a binder to be contained in the individual green sheets 30 in the next step (degreasing step S15) to decompose. For the above-described reasons, the number of the individual green sheets 30 to be stacked in the present step is 8 to 100 and preferably 30 to 70.

In addition, the non-reactive powder layer of the present embodiment is, as an example, a boron nitride powder layer (BN powder layer) having a film thickness of about 1 um to 20 um. The BN powder layer has a function of easily separating the ceramic substrate 40 after the next step (sintering step S2). The BN powder layer is applied as a slurry of BN powder to one surface of each individual green sheet 30 by, for example, spraying, brush application, roll coating, screen printing, or the like. The BN powder has a purity of equal to or higher than 85% and preferably has an average particle size of 1 um to 20 µm.

Hitherto, the deposition step S14 has been described.

### [Degreasing step]

Next, the degreasing step S15 will be described. The present step is a step for degreasing the binder and the plasticizer contained in the individual green sheets 30 before the next step (sintering step S2).

In the present step, as an example, the plurality of individual green sheets 30 stacked in the deposition step S14 (refer to Fig. 3A) are held in a temperature environment of 450°C to 750°C for 0.5 hours to 20 hours. As a result, the binder and the plasticizer contained in the plurality of individual green sheets 30 are degreased.

Hitherto, the degreasing step S15 has been described. In addition, the green sheet-forming step S1 of the present embodiment has been thus far described.

### <Sintering step>

Next, the sintering step S2 will be described with reference to Fig. 3A to Fig. 3F. The present step is a step of sintering the plurality of individual green sheets 30 which have been stacked in the deposition step S14 and in which the binder and the plasticizer have been degreased in the degreasing step S15 (hereinafter, referred to as the plurality of individual green sheets 30 in Fig. 3A) using a sintering device (not shown).

The sintering device includes a sintering furnace and a control device. The sintering furnace has a temperature adjustment mechanism, a firing chamber, and a thermometer for measuring the temperature in the firing chamber. The temperature adjustment mechanism has a temperature raising portion for raising the temperature in the firing chamber (as an example, a heater) and a cooling portion for cooling the inside of the firing chamber (as an example, a water cooling pipe). Then, in the present step, the control device controls the temperature adjustment mechanism such that the temperature in the firing chamber changes according to a temperature following a temperature control program to be described below in a state where the plurality of individual green sheets 30 of Fig. 3A are disposed in the sintering chamber.

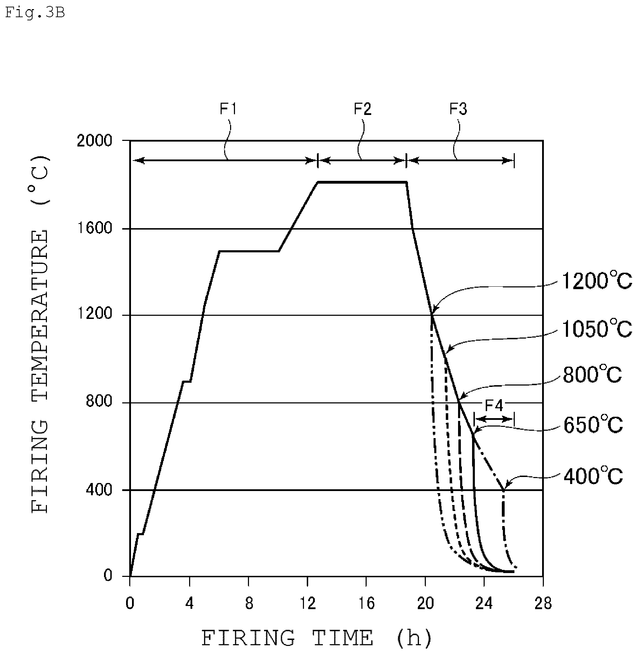

The temperature control program is stored in a storage device (for example, ROM or the like) in the control device. In addition, the temperature control program is a program for the control device to perform a temperature control (for example, a PID control or the like) with the temperature adjustment mechanism while referring to temperature information from the thermometer. Specifically, the temperature control program is a program made up of a temperature raising region F1 having a slow heating region, a temperature holding region F2, and a cooling region F3 and intended to make a temperature profile in the firing chamber follow a profile progressing in the above-described order (refer to Fig. 3B). Hereinafter, the technical meanings of the temperature raising region F1, the temperature holding region F2, and the cooling region F3 will be described.

### [Temperature raising region]

The temperature raising region F1 is a temperature region for the sintering aid contained in each individual green sheet 30 to react with oxide layers on the surfaces of silicon nitride particles to generate a liquid phase. As shown in Fig. 3B, in the temperature raising region F1 of the present embodiment, as an example, the temperature is preferably raised in a stepwise manner from room temperature to a temperature within a range of 1600°C to 2000°C (in the case of the present embodiment, about 1800°C as an example) for 12 hours. In the temperature raising region F1, the grain growth of α-type silicon nitride is suppressed, and the silicon nitride particles are rearranged and densified in the liquefied sintering aid. As a result, after the next temperature holding region F2, the ceramic substrate 40 in which the pore diameters and the porosity are small, the bending strength is strong, and the thermal conductivity is high is obtained. In addition, in order to suppress the decomposition of silicon nitride in a temperature region of equal to or higher than 1200°C, the individual green sheets 30 are preferably fired under nitrogen pressurization (0.8 MPa to 0.9 MPa).

### [Temperature holding region]

The temperature holding region F2 is a temperature region for promoting the rearrangement of silicon nitride particles, the generation of β-type silicon nitride crystals, and the grain growth of silicon nitride crystals from the liquid phase generated in the temperature raising region F1 and further densifying the ceramic substrate 40, which is a sintered body.

Considering the size and aspect ratio (ratio of major axis to minor axis) of *β*-type silicon nitride particles and the formation of pores due to volatilization of sintering aid, it is preferable that the temperature in the temperature holding region F2 should be in the range of 1600°C to 2000°C and the holding time should be 1 hour to 30 hours (in the case of the present embodiment, about 8 hours as an example). When the temperature in the temperature holding region F2 is lower than 1600°C, it is difficult to densify the ceramic substrate 40. On the other hand, when the temperature of the temperature holding region F2 exceeds 2000°C, the volatilization of the sintering aid and the decomposition of silicon nitride become severe, and the ceramic substrate 40 is difficult to be densified. When the temperature in the temperature holding region F2 is within the range of 1600°C to 2000°C, the temperature in the temperature holding region F2 may be set so as to change with time (for example, the temperature may be set so as to slowly raising the temperature).

Here, the temperature of the temperature holding region F2 is more preferably a temperature within a range of 1750°C to 1950°C and still more preferably a temperature within a range of 1800°C to 1900°C. Furthermore, the temperature of the temperature holding region F2 is preferably equal to or more than 50°C higher and more preferably equal to or more than 100°C to 300°C higher than the upper limit of the temperature of the slow heating region F1. The holding time of the temperature holding region F2 is more preferably 2 hours to 20 hours, still more preferably 3 hours to 10 hours.

### [Cooling region (including rapid cooling region)]

The cooling region F3 is a temperature region for cooling and solidifying the liquid phase maintained in the temperature holding region F2 and fixing the locations of grain boundary phases to be obtained. The cooling region F3 of the present embodiment includes a rapid cooling region F4 to be described below.

The cooling rate of the cooling region F3 is preferably equal to or faster than 100 °C/hour, more preferably equal to or faster than 300 °C/hour, and still more preferably equal to or faster than 500 °C/hour in order to rapidly solidify the liquid phase to maintain the uniformity of the grain boundary phase distribution. A practical cooling rate is preferably 500 °C/hour to 600 °C/hour. The cooling of the liquid phase at a cooling rate as described above suppresses the crystallization of the solidifying sintering aid and forms grain boundary phases mainly containing a glass phase. As a result, it is possible to increase the bending strength of the ceramic substrate 40.

As described above, the cooling region F3 is a temperature region after the temperature raising region F1 and the temperature holding region F2 in the temperature control program (refer to Fig. 3B). Therefore, the cooling region F3 of the present embodiment can be said to be a temperature region in which the inside of the firing chamber is cooled after the temperature in the firing chamber is heated until the inside of the firing chamber reaches at least equal to or higher than 1600°C in the temperature raising region F1 and the temperature holding region F2 (refer to Fig. 3B).

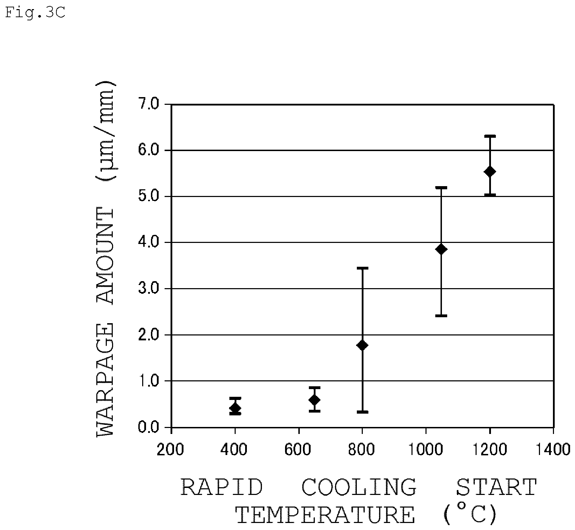

Next, the rapid cooling region F4 will be described with reference to Fig. 3B. The cooling region F3 of the present embodiment has a temperature region in which the cooling temperature rate is further increased in the middle of the progress. In the present embodiment, this "temperature region in which the cooling rate is further increased" is referred to as the rapid cooling region F4. The rapid cooling region F4 of the present embodiment is started in a case where, as an example, the temperature in the firing chamber reaches any temperature of equal to or higher than 900°C and equal to or lower than 1200°C. In the present embodiment, the time for performing the rapid cooling region F4 is, as an example, a time of about equal to or shorter than half of the time for performing the cooling region F3. The technical meaning of setting the rapid cooling region F4 in the cooling region F3 (refer to Fig. 3C to Fig. 3F and the like) will be described below.

When the present step is completed, a plurality of the ceramic substrates 40 are manufactured in a stacked state (refer to Fig. 3A).

Hitherto, the sintering step S2 has been described.

### <Outer peripheral portion-cutting step (cutting step of ceramic substrate 40)>

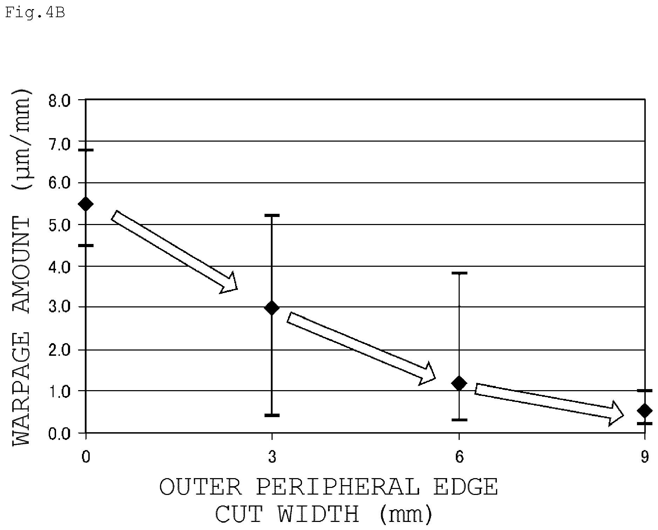

Next, the outer peripheral portion-cutting step S3 will be described with reference to Fig. 4A. The present step is a step (cutting step) of cutting portions on the entire peripheral edge sides of the ceramic substrate 40 manufactured through the sintering step S2. Specifically, in the present step, as an example of the entire peripheral edge sides of the ceramic substrate 40 after the sintering step S2, at least 3 mm-wide portions are cut using a laser processing machine (not shown). In this case, the laser beam source of the laser processing machine intermittently radiates laser beams along the portions to be cut. As a result, a ceramic substrate 40 from which the portions of the entire peripheral edges have been cut is manufactured by the present step. The technical meaning of performing the present step (refer to Fig. 4B) will be described below. In addition, in the present embodiment, the present step is performed by intermittently radiating laser beams using a laser processing machine, but the present step may be performed by a different method as long as the portions of the outer peripheral edges can be cut. For example, the cutting method by the continuous radiation of laser beams may be a cutting method by polishing or a different cutting method.

Hitherto, the outer peripheral portion-cutting step S3 has been described. In addition, the manufacturing method of the ceramic substrate 40 of the present embodiment has been thus far described.

### [Technical meaning of setting rapid cooling region F4 in cooling region F3]

Next, the technical meaning of setting the rapid cooling region F4 in the cooling region F3 will be described with reference to Fig. 3B and Fig. 3C.

Here, Fig. 3B is a graph showing a profile of the firing temperatures in the sintering step S2 (also including conditions studied by a test). As described above, in the present embodiment, as an example, in a case where the temperature in the firing chamber reaches any temperature of 900°C to 1100°C, the rapid cooling region F4 is started. Here, as shown by the graph of Fig. 3B, the inventors of the present application performed a test for measuring the warpage amounts of the ceramic substrate 40 in a case where the start temperature of the rapid cooling region F4 (rapid cooling start temperature) was set to 1200°C, 1050°C, 800°C, 650°C, and 400°C. Fig. 3C is a graph of the results, that is, a graph showing the relationship between the rapid cooling start temperatures in the sintering step S2 and the warpage amounts. According to the graph of Fig. 3C, it is found that as the rapid cooling start temperature lowers, the warpage amount of the ceramic substrate 40 tends to decrease. In addition, the warpage amount is, as an example, preferably a maximum of equal to or less than 6 um. That is, in the present embodiment, the maximum permissible value of the warpage amount is, as an example, 6 um. The reason therefor is that it becomes possible to easily handle the ceramic substrate 40 at the time of the circuit pattern-forming step (resist printing step S6 and etching step S7) or the electronic component mounting step S10. In addition, as is clear from the graph of Fig. 3C, as the rapid cooling start temperature increases, the warpage amount increases, and the warpage amount further varies. This means that, as the rapid cooling start temperature increases, the influence of a partial strain in the ceramic substrate 40 due to the rapid cooling becomes larger.

Incidentally, as is clear from the graph of Fig. 3C, in a case where the rapid cooling start temperature is 400°C to 1100°C and is 400°C, the warpage amount of the ceramic substrate 40 becomes less than the maximum permissible value of the warpage amount (in this case, 2 pm/mm to less than 6 pm/mm) even when variation in the warpage amount is taken into consideration. In addition, when the rapid cooling start temperature is extremely lowered (for example, equal to or lower than 400°C), the productivity is decreased due to the extension of the firing time.

Therefore, in the present embodiment, an appropriate range of the rapid cooling start temperature is set to 900°C to 1100°C in consideration of the balance between the warpage amount and the shortening of the firing time.

When the shortening of the firing time is not taken into consideration, the rapid cooling start temperature may be set to lower than 650°C.

What has been described above is the technical meaning of setting the rapid cooling region F4 in the cooling region F3.

### [Technical meaning of performing outer peripheral portion-cutting step S3]

Next, the technical meaning of performing the outer peripheral portion-cutting step S3 will be described with reference to Fig. 4B.

The inventors of the present application performed a test for measuring the warpage amounts of the ceramic substrate 40 in cases where the cut widths of the outer peripheral portions were set to 0 mm (no cutting), 3 mm, 6 mm, and 9 mm taking a case where the rapid cooling start temperature was 650°C as an example. Fig. 4B is a graph of the results, that is, a graph showing the relationship between the cut widths of the outer peripheral portions and the warpage amounts in the outer peripheral portion-cutting step S3. As is clear from the graph of Fig. 4B, it is found that, as the cut width of the outer peripheral portion increases, the warpage amount decreases. In addition, it is found that, as the cut width of the outer peripheral portion increases, the variation in the warpage amount decreases. The reason therefor is considered that, since a compressive stress or tensile stress applied due to the influence of cooling increases as the portion comes closer to the outer peripheral portion in the ceramic substrate 40, the ceramic substrate 40 is released from such stress by cutting such a portion. In addition, when the results of the graph of Fig. 4B are taken into account, it is necessary to cut the outer peripheral portions. However, since the cut outer peripheral portions of the ceramic substrate 40 are discarded, that is, the amount of the cut outer peripheral portions discarded increases as the cut widths increase, the cut widths of the outer peripheral portions are preferably narrow.

Therefore, in the present embodiment, the cut width of the outer peripheral portion is preferably set to at least 3 mm.

What has been described above is the technical meaning of performing the outer peripheral portion-cutting step S3.

Hitherto, the features and the like of the ceramic substrate 40 of the present embodiment have been described.

### <Scribe line-forming step>

Next, the SL forming step S4 will be described with reference to Fig. 5. The present step is a step of forming a plurality of scribe lines SL (three in the present embodiment as an example) on one surface of the ceramic substrate 40 (the front surface 40A1 in the present embodiment as an example). When the present step is completed, an SL-drawn ceramic substrate 40A is manufactured.

In the present step, as an example, a total of three linear portions, that is, one linear portion passing through the center in the width direction and two linear portions equally dividing the ceramic substrate 40 in the length direction are formed on the front surface 40A1 of the ceramic substrate 40 with laser beams radiated from the radiation portion (not shown), and the entire region of the front surface 40A1 is partitioned into six equally-divided regions. Here, each scribe line SL is made up of a plurality of concave portions linearly arranged as an example (refer to Fig. 6B). Therefore, the radiation portion that is used in the present step (as an example, a carbon dioxide laser beam source, a YAG laser beam source, or the like) is capable of, for example, intermittently radiating laser beams.

Each scribe line SL is used as a cutting line at the time of dividing the ceramic substrate 40 into a plurality of parts (six in the present embodiment) in the dividing step S9 (refer to Fig. 1), which is a below step.

Hitherto, the SL forming step S4 has been described.

### <Metal layer-forming step>

Next, the metal layer-forming step S5 will be described with reference to Fig. 6A and Fig. 6B.

The present step is a step of fixing the first metal layer 50A and the second metal layer 50B to the front surface 40A1 side and the rear surface 40A2 side of the SL-drawn ceramic substrate 40A, respectively. In this case, the first metal layer 50A and the second metal layer 50B are fixed to the front surface 40A1 side and the rear surface 40A2 side, respectively, through a brazing material (not shown). Specifically, a paste-like brazing material is uniformly applied to the front surface 40A1 and the rear surface 40A2 of the ceramic substrate 40 by a method such as a roll coating method, a screen printing method, or a transfer method, and furthermore, the first metal layer 50A and the second metal layer 50B are joined to the front surface 40A1 and the rear surface 40A2 of the ceramic substrate 40, respectively, through the uniformly-applied paste-like brazing material. Here, in the present step, a screen printing method is preferable from the viewpoint of uniformly applying the paste-like brazing material. In addition, in this case, the clay of the paste-like brazing material is preferably controlled to 5 Pa·s to 20 Pa·s. An excellent paste-like brazing material can be obtained by blending an organic solvent in an amount of 5% by mass to 7% by mass and a binder in an amount within a range of 2% by mass to 8% by mass with the paste-like brazing material. When the present step is completed, the motherboard 60 is manufactured.

Fig. 6B shows a state where microcracks MC extending from the plurality of concave portions configuring the scribe line SL, respectively, to the rear surface 40A2 are formed, and the microcracks MC are formed at the time of the dividing step S9 to be described below. In addition, the microcracks MC are also formed at the time of the outer peripheral portion-cutting step S3.

Hitherto, the metal layer-forming step S5 has been described.

### <Resist printing step>

Next, the resist printing step S6 will be described with reference to Fig. 7. The present step is a step of coating the first metal layer 50A of the motherboard 60 with a photosensitive resist film PRF and forming resist patterns PRP corresponding to individual circuit patterns CP to be described below in six regions partitioned by the three scribe lines SL on the first metal layer 50A. Specifically, in the present step, the resist patterns PRP are printed on the resist film PRF using, as an example, an exposure device (not shown) (the resist patterns PRP are cured, and portions other than the resist patterns PRP in the resist film PRF are left uncured). As a result, the PRP-drawn motherboard 60A is manufactured.

Hitherto, the resist printing step S6 has been described.

### <Etching step>

Next, the etching step S7 (an example of the circuit pattern-forming step) will be described with reference to Fig. 8. The present step is a step of removing the uncured resist film PRF from the resist film PRF of the PRP-drawn motherboard 60A, etching portions where the first metal layer 50A is exposed, and then the remaining resist patterns PRP are removed to form the circuit pattern CP. As a result, the PRP-drawn motherboard 60A before the present step becomes the assembly substrate 60B in which the circuit pattern CP is formed in each of the six regions partitioned by the three scribe lines SL. In addition, when the assembly substrate 60B is formed, all of the portions of the three scribe lines SL formed in the SL forming step S4 are exposed due to the etching of the first metal layer 50A.

Electronic components (not shown) such as an IC, a capacitor, and a resistor are mounted on individual circuit patterns CP formed in the present step in the mounting step S10 to be described below. In addition, in the above description, the etching step S7 is described as an example of the circuit pattern-forming step, but the combination of the resist printing step S6 and the etching step S7 may be regarded as an example of the circuit pattern-forming step.

Hitherto, the etching step S7 has been described.

### <Surface treatment step>

Next, the surface treatment step S8 will be described. The present step is a step of performing a surface treatment on portions other than joint portions to which the electronic components are to be joined on the surface of the assembly substrate 60B on which the plurality of (six in the present embodiment) circuit patterns CP have been formed by coating the portions other than the joint portions with a protective layer such as a solder resist (not shown). In addition, in the present step, a surface treatment of the joint portions is performed by performing a plating treatment by, for example, the electrolytic plating method on the joint portions to which the electronic components are to be joined. Here, in the above description, a product at the time of the completion of the etching step S7 is the assembly substrate 60B, but the product at the completion of the surface treatment step S8, that is, a substrate obtained by coating the assembly substrate 60B with the protective layer may be regarded as the assembly substrate.

Hitherto, the surface treatment step S8 has been described.

### <Dividing step>

Next, the dividing step S9 will be described with reference to Fig. 9. The present step is a step of dividing the assembly substrate 60B (or the SL-drawn ceramic substrate 40A) into a plurality of (six in the present embodiment as an example) the circuit substrates 60C by cutting the assembly substrate 60B along the plurality of (three in the present embodiment as an example) scribe lines SL.

When the present step is completed, a plurality of the circuit substrates 60C are manufactured. In the case of the present embodiment, the first metal layer 50A becomes the circuit pattern CP of each circuit substrate 60C by the steps described thus far. On the other hand, each region partitioned by the three scribe lines SL in the second metal layer 50B becomes the metal layer on the side of each circuit substrate 60C opposite to the side on which the circuit pattern CP has been formed by the steps described thus far. In addition, the metal layer functions as a heat dissipation layer for dissipating heat generated from the electronic component mounted on the circuit pattern CP while the mounting substrate (not shown) to be manufactured by the mounting step S10 to be described below is in use.

Hitherto, the dividing step S9 has been described.

In the description of the manufacturing method of the present embodiment thus far, the metal layer-forming step S5 is performed on the motherboard 60, and then the dividing step S9 is performed, however, for example, the dividing step S9 may be performed after the scribe line-forming step S4 and then the surface treatment step S8 may be performed after the metal layer-forming step S5.

### <Mounting step>

Next, the mounting step S10 will be described. The present step is a step of mounting the electronic component (not shown) on each circuit substrate 60C (refer to Fig. 9). In the present step, solder (not shown) is attached to the joint portion to which the electronic component is to be joined on the circuit pattern CP on each circuit substrate 60C (refer to Fig. 9) using a mounting device (not shown), and a joint terminal of the electronic component is attached to the joint portion.

When the present step is completed, a plurality of the mounting substrates are manufactured. In the above description, the present step is a step after the dividing step S9, but the dividing step S9 may be performed after the present step. That is, the manufacturing method S100 of the present embodiment may be performed in the order of the mounting step S10 and the dividing step S9 after the surface treatment step S8.

Hitherto, the mounting step S10 has been described. After the manufacturing of the plurality of mounting substrates, inspection of the circuit patterns CP, inspection of the operation of the electronic components, and the like are performed using, for example, an inspection device (not shown).

The manufacturing method S100 of the present embodiment has been thus far described.

### «Effects of the present embodiment»

Next, the effects of the present embodiment will be described.

### <First effect>

In the ceramic substrate 40 of the present embodiment, as shown in Fig. 3D to Fig. 3F, the shape is rectangular in the plan view, in a case where the intersection formed by the pair of diagonal lines of the ceramic substrate is regarded as a reference in the sheet thickness direction of the ceramic substrate 40, out of the four regions divided by the pair of diagonal lines, one pair of the pair of first regions facing each other across the intersection and the pair of second regions facing each other across the intersection is located on one side in the sheet thickness direction with respect to the intersection, the other pair is located on the other side in the sheet thickness direction with respect to the intersection, and the value obtained by dividing the maximum projection amount in the sheet thickness direction of the ceramic substrate 40 by the length of the diagonal line of the ceramic substrate 40 is equal to or less than 6 pm/mm.

Specifically, the ceramic substrate 40 of the present embodiment is manufactured by controlling the forced cooling temperature and has residual thermal stress remaining to an appropriate extent and thereby warps in a saddle shape. In addition, the ceramic substrate 40 warped in a saddle shape curves continuously, the warpage is easily corrected when the ceramic substrate 40 is laminated with metal sheets (the first metal layer 50A and the second metal layer 50B), and the ceramic substrate 40 becomes a flat shape.

Therefore, the ceramic substrate 40 of the present embodiment has excellent adhesion to the metal sheets (the first metal layer 50A and the second metal layer 50B) and has an excellent joining property with the metal sheets (the first metal layer 50A and the second metal layer 50B). In other words, the ceramic substrate 40 of the present embodiment has the above-described configuration and thereby enables the production of a circuit substrate having excellent flatness.

### <Second effect>

In the ceramic substrate 40 of the present embodiment, as shown in Fig. 3D to Fig. 3F, the shape is rectangular in the plan view, in the first cut surface cut by the first straight line L1 that passes through the center and is parallel to any one side out of the four sides in the plan view, the central portion in the length direction curves in a convex shape toward one side in the sheet thickness direction, in the second cut surface cut by the second straight line L2 that passes through the center and is orthogonal to the first straight line L1, the central portion in the length direction curves in a convex shape toward the other side in the sheet thickness direction, and the value obtained by dividing the maximum projection amount in the sheet thickness direction of the ceramic substrate 40 by the length of the diagonal line of the ceramic substrate 40 is equal to or less than 6 pm/mm.

In addition, as described above, the ceramic substrate 40 of the present embodiment is processed into the circuit substrate 60C (refer to Fig. 9) by fixing the first metal layer 50A and the second metal layer 50B to both surface sides thereof, respectively. Therefore, various heat histories are applied to the ceramic substrate 40 of the present embodiment in a state where the first metal layer 50A and the second metal layer 50B are fixed to both surface sides thereof, respectively (a state of the motherboard 60). That is, thermal strain or thermal stress is generated inside the motherboard 60.

However, the ceramic substrate 40 of the present embodiment has the above-described configuration, whereby it is possible to produce a circuit substrate having excellent flatness in which residual thermal strain or residual thermal stress is significantly reduced.

In addition, for example, in the case of a ceramic substrate in which the curvatures locally change, in a region where the curvatures locally change as described above, the adhesion to the metal sheets (the first metal layer 50A and the second metal layer 50B) deteriorates, poor joint is caused, and the warpage amount as a circuit substrate may increase.

However, since the ceramic substrate 40 of the present embodiment warps in a saddle shape, that is, there is no region where the curvatures locally change, the adhesion to the metal sheets (the first metal layer 50A and the second metal layer 50B) is excellent, poor joint is suppressed, and the warpage amount as a circuit substrate is reduced.

### <Third effect>

In the ceramic substrate 40 of the present embodiment, as shown in Fig. 3D to Fig. 3F, in the first parallel cut surfaces, which are parallel to the first cut surface at the individual locations extending to both ends of the ceramic substrate 40 in the direction along the first straight line L1 from the center, the central portions thereof in the length direction curve in a convex shape toward one side in the sheet thickness direction, and, in the first parallel cut surfaces at the individual locations, the curvatures continuously increase from the center through both ends of the ceramic substrate 40 in the direction along the second straight line.

Therefore, the ceramic substrate 40 of the present embodiment has the above-described configuration, whereby it is possible to produce a circuit substrate having excellent flatness in which residual thermal strain or residual thermal stress is significantly reduced.

In addition, for example, in the case of a ceramic substrate in which the curvatures locally change, that is, in a case where, in the first parallel cut surfaces at the individual locations, the curvatures do not continuously increase from the center to both ends of the ceramic substrate 40 in the direction along the second straight line, in a region where the curvatures locally change as described above, the adhesion to the metal sheets (the first metal layer 50A and the second metal layer 50B) deteriorates, poor joint is caused, and the warpage amount as a circuit substrate may increase.

However, since the ceramic substrate 40 of the present embodiment warps in a saddle shape, that is, there is no region where the curvatures locally change, the adhesion to the metal sheets (the first metal layer 50A and the second metal layer 50B) is excellent, poor joint is suppressed, and the warpage amount as a circuit substrate is reduced.

### <Fourth effect>

In the ceramic substrate 40 of the present embodiment, as shown in Fig. 3D to Fig. 3F, in the second parallel cut surfaces, which are parallel to the second cut surface at the individual locations extending to both ends of the ceramic substrate 40 in the direction along the second straight line L2 from the center, the central portions thereof in the length direction curve in a convex shape toward the other side in the sheet thickness direction, and, in the second parallel cut surfaces at the individual locations, the curvatures continuously decrease from the center to both ends of the ceramic substrate 40 in the direction along the first straight line.

Therefore, the ceramic substrate 40 of the present embodiment has the above-described configuration, whereby it is possible to produce a circuit substrate in which residual thermal strain or residual thermal stress is significantly reduced and the flatness is excellent.

In addition, for example, in the case of a ceramic substrate in which the curvatures locally change, that is, in a case where, in the second parallel cut surfaces at the individual locations, the curvatures do not continuously decrease from the center to both ends of the ceramic substrate 40 in the direction along the first straight line, in a region where the curvatures locally change as described above, the adhesion to the metal sheets (the first metal layer 50A and the second metal layer 50B) deteriorates, poor joint is caused, and the warpage amount as a circuit substrate may increase.

However, since the ceramic substrate 40 of the present embodiment warps in a saddle shape, that is, there is no region where the curvatures locally change, the adhesion to the metal sheets (the first metal layer 50A and the second metal layer 50B) is excellent, poor joint is suppressed, and the warpage amount as a circuit substrate is reduced.

### <Fifth effect>

For example, in the case of a ceramic substrate having a different shape from the ceramic substrate 40 of the present embodiment and having local unevenness or the like, there is a concern that it may not be possible to correct the shape (local unevenness or the like) at the time of bonding the ceramic substrate to the metal sheets (the first metal layer 50A and the second metal layer 50B) and poor joint may be caused.

On the other hand, in the case of the ceramic substrate 40 of the present embodiment, the ceramic substrate 40 warps in a saddle shape, and the value obtained by dividing the maximum projection amount in the sheet thickness direction of the ceramic substrate 40 by the length of the diagonal line of the ceramic substrate 40 is equal to or less than 6 pm/mm.

Therefore, according to the ceramic substrate 40 of the present embodiment, it is possible to produce a circuit substrate having excellent adhesion to the metal sheets (the first metal layer 50A and the second metal layer 50B) and a favorable joining property.

### <Sixth effect>

As shown in Fig. 6A and Fig. 6B, the motherboard 60 of the present embodiment includes the ceramic substrate 40, the first metal layer 50A fixed to the front surface 40A1 side of the ceramic substrate 40, and the second metal layer 50B fixed to the rear surface 40A2 side of the ceramic substrate 40.

In addition, the ceramic substrate 40 included in the motherboard 60 of the present embodiment has the above-described first to fourth effects.

Therefore, the motherboard 60 of the present embodiment includes the ceramic substrate 40 of the present embodiment, whereby residual thermal strain or residual thermal stress is significantly reduced and the flatness is excellent.

### <Seventh effect>

As shown in Fig. 9, the circuit substrate 60C of the present embodiment includes the ceramic substrate 40, the circuit pattern CP formed on one surface side of the ceramic substrate 40 (in the present embodiment, on the front surface 40A1 side as an example), and the metal layer fixed to the other surface side (in the present embodiment, to the rear surface 40A2 side as an example) of the ceramic substrate 40 (the second metal layer 50).

In addition, the ceramic substrate 40 included in the circuit substrate 60C of the present embodiment has the above-described first to fourth effects.

Therefore, the circuit substrate 60C of the present embodiment includes the ceramic substrate 40 of the present embodiment, whereby residual thermal strain or residual thermal stress is significantly reduced and the flatness is excellent.

### <Eighth effect>

The manufacturing method of the ceramic substrate 40 of the present embodiment includes the cutting step of cutting the strip-shaped green sheet 20 containing the ceramic powder to obtain the individual green sheet 30 (refer to Fig. 2B, Fig. 2C, and the like) and the sintering step of disposing the individual green sheet 30 in the firing chamber, heating the inside of the firing chamber until the temperature in the firing chamber reaches at least equal to or higher than 1600°C, then, cooling the inside of the firing chamber, and sintering the individual green sheet 30 to obtain the ceramic substrate 40, and, in the sintering step, the temperature in the firing chamber is rapidly cooled in a case where the temperature in the firing chamber at the time of cooling the inside of the firing chamber has reached equal to or lower than 650°C (refer to Fig. 3B).

As a result, according to the manufacturing method of the ceramic substrate 40 of the present embodiment, it is possible to manufacture the ceramic substrate 40 in which residual thermal strain or residual thermal stress is significantly reduced and the flatness is excellent (refer to Fig. 3C).

### <Ninth effect>

The manufacturing method of the ceramic substrate 40 of the present embodiment further includes the cutting step of cutting the entire peripheral edges of the ceramic substrate 40 cooled after the sintering step (refer to Fig. 4A).

As a result, the ceramic substrate 40 from which the entire peripheral edges have been cut is released from a state where a compressive stress or tensile stress is applied due to the influence during the cooling, that is, particularly, stress in the outer peripheral edges.

As a result, according to the manufacturing method of the ceramic substrate 40 of the present embodiment, it is possible to manufacture the ceramic substrate 40 in which residual thermal strain or residual thermal stress is significantly reduced and the flatness is excellent (refer to Fig. 4B).

### <Tenth effect>

The manufacturing method of the motherboard 60 of the present embodiment includes the manufacturing method of the ceramic substrate 40 of the present embodiment and the fixing step of fixing the first metal layer 50A to the front surface 40A1 side of the ceramic substrate 40 and fixing the second metal layer 50B to the rear surface 40A2 side (refer to Fig. 6A) .

In addition, the manufacturing method of the ceramic substrate 40 of the present embodiment exhibits the above-described seventh effect.

Therefore, according to the manufacturing method of the motherboard 60 of the present embodiment, it is possible to manufacture the motherboard 60 in which residual thermal strain or residual thermal stress is significantly reduced and the flatness is excellent.

### <Eleventh effect>

The manufacturing method of the circuit substrate 60C of the present embodiment includes the manufacturing method of the motherboard 60 of the present embodiment and the pattern-forming step of forming the circuit pattern CP on at least one of the first metal layer 50A and the second metal layer 50B (in the case of the present embodiment, the first metal layer 50A) (refer to Fig. 7, Fig. 8, and the like).

In addition, the manufacturing method of the motherboard 60 of the present embodiment exhibits the above-described eighth effect.

Therefore, according to the manufacturing method of the circuit substrate 60C of the present embodiment, it is possible to manufacture the circuit substrate 60C in which residual thermal strain or residual thermal stress is significantly reduced and the flatness is excellent.

Hitherto, the effects of the present embodiment have been described. In addition, the present embodiment has been thus far described.

### <<Modification examples>>

As described above, an example of the present invention has been described with reference to the above-described embodiment (refer to Fig. 1 to Fig. 9), but the present invention is not limited to the above-described embodiment. The technical scope of the present invention also includes, for example, forms as described below (modification examples).

For example, in the description of the present embodiment, description was made using silicon nitride as an example of the ceramic powder. However, the example of the ceramic powder may be a different ceramic powder. For example, the ceramic powder may be an aluminum nitride powder.

In addition, in the description of the molding step S12 (refer to Fig. 2A) included in the green sheet-forming step S1 of the present embodiment, the molding step S12 was performed using the doctor blade molding. However, the molding step S12 may be performed by a different method as long as it is possible to mold the slurry 10 into the strip-shaped green sheet 20. For example, the molding step S12 may be performed by extrusion molding.

In addition, in the description of the cutting step S13 (refer to Fig. 2A) included in the green sheet-forming step S1 of the present embodiment, the strip-shaped green sheet 20 was cut while the radiation portion 224 was moved from one end side to the other end side of the strip-shaped green sheet 20 in the lateral direction. However, as long as the individual green sheet 30 can be consequently obtained by cutting the strip-shaped green sheet 20, the cutting site of the strip-shaped green sheet 20 may not be a linear portion from one end side to the other end side of the strip-shaped green sheet 20 in the lateral direction as in the case of the present embodiment. For example, the strip-shaped green sheet 20 may be cut so as to separate (or hollow out) the individual green sheet 30 from the strip-shaped green sheet 20 by opening pilot holes in the form of the individual green sheet 30 in the strip-shaped green sheet 20. That is, at least a part of the entire end faces of the individual green sheet 30 obtained by cutting the strip-shaped green sheet 20 needs to be a cut surface.

In addition, in the present embodiment, the circuit pattern CP has been described to be formed on the first metal layer 50A. However, the circuit pattern CP may be formed on the second metal layer 50B without forming the circuit pattern CP on the first metal layer 50A. That is, in the pattern-forming step (the resist printing step S6 and the etching step S7), at least one circuit pattern CP may be formed on any one of the first metal layer 50A and the second metal layer 50B.

In addition, in the present embodiment, the plurality of linearly-arranged concave portions have been described as the scribe lines SL (refer to Fig. 6B). However, the scribe lines SL may be, for example, continuous grooves, a plurality of concave portions having different lengths, widths, or the like, or the like as long as the function can be exhibited.

In addition, in the present embodiment, the plurality of scribe lines SL have been described as three scribe lines SL (refer to Fig. 5). However, the number of the plurality of scribe lines SL may be at least equal to or more than one.

In addition, in the present embodiment, the plurality of scribe lines SL have been described to equally divide the motherboard 60 into six parts (refer to Fig. 5). However, the plurality of scribe lines SL may not equally divide the motherboard 60.

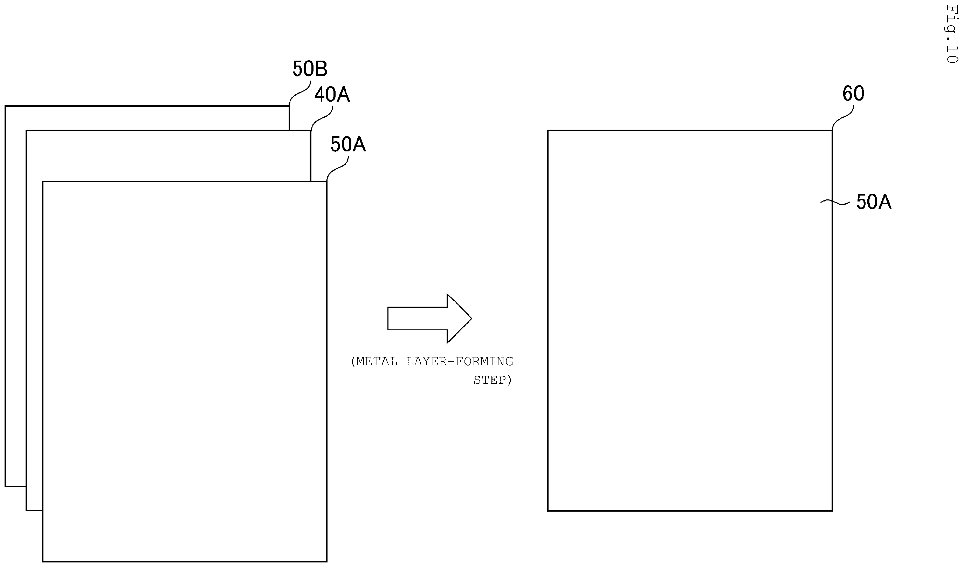

In addition, in the manufacturing method S100 of the present embodiment, it has been described that the SL forming step S4 was performed (refer to Fig. 1). However, as in a modification example shown in Fig. 10, the metal layer-forming step S5 may be performed without performing the SL forming step S4 after the outer peripheral portion-cutting step S3. In the case of this modification example, if the mounting step S10 is performed without performing the dividing step S9 after the surface treatment step S8 (refer to Fig. 1), one mounting substrate is manufactured from one motherboard 60.

In addition, the manufacturing method of the ceramic substrate 40 of the present embodiment has been described to include the outer peripheral portion-cutting step S3 (refer to Fig. 1, Fig. 4A, and Fig. 4B). However, depending on the conditions of the sintering step S2, since it is possible to suppress the warpage amount of the ceramic substrate 40 to equal to or less than the maximum permissible value, the outer peripheral portion-cutting step S3 may not be an essential configuration element.

This application claims priority on the basis of Japanese Patent Application No. 2019-206750 filed on November 15, 2019.

### REFERENCE SIGNS LIST

- 10:: Slurry
- 20:: Strip-shaped green sheet
- 30:: Individual green sheet
- 40:: Ceramic substrate
- 40A:: SL-drawn ceramic substrate
- 40A1:: Front surface
- 40A2:: Rear surface
- 50A:: First metal layer
- 50B:: Second metal layer
- 60:: Motherboard (example of composite substrate)
- 60A:: PRP-drawn motherboard
- 60B:: Assembly substrate
- 60C:: Circuit substrate
- 100:: Doctor blade molding device
- 110:: Belt transport mechanism
- 112:: Roller
- 112A:: Roller
- 112B:: Roller
- 114:: Belt
- 120:: Molding unit
- 122:: Accommodation portion
- 124:: Doctor blade
- 130:: Heating unit
- 200:: Cutting device
- 210:: Sheet transport mechanism
- 212:: Support portion
- 214:: First transport portion
- 216:: Second transport portion
- 220:: Cutting portion
- 222:: Housing
- 224:: Radiation portion
- 226:: Moving mechanism
- CP:: Circuit pattern
- F1:: Temperature raising region
- F1:: Slow heating region
- F2:: Temperature holding region
- F3:: Cooling region
- F4:: Rapid cooling region
- L1:: Straight line (first straight line)
- L2:: Straight line (second straight line)
- LB:: Laser beam
- MC:: Microcrack
- O:: Intersection, center
- PRF:: Resist film
- PRP:: Resist pattern
- S1:: Green sheet-forming step
- S10:: Mounting step
- S11:: Slurry production step
- S12:: Molding step
- S13:: Cutting step
- S14:: Deposition step
- S15:: Degreasing step
- S2:: Sintering step
- S3:: Outer peripheral portion-cutting step
- S4:: SL forming step (scribe line-forming step)
- S5:: Metal layer-forming step
- S6:: Resist printing step
- S7:: Etching step
- S8:: Surface treatment step
- S9:: Dividing step
- S100:: Manufacturing method of plurality of mounting substrates
- SL:: Scribe line
- WC:: Warm air
- ΔZ₁:: Projection amount
- ΔZ₂:: Projection amount
- ΔZ₃:: Projection amount

## Claims

1. A ceramic substrate (40) having a rectangular shape in a plan view,
wherein, in a first cut surface cut by a first straight line (L1) that passes through a center (O) of the ceramic substrate (40) and is parallel to any one side out of four sides in the plan view, a central portion in a length direction curves in a convex shape toward one side in a sheet thickness direction, and
in a second cut surface cut by a second straight line (L2) that passes through the center (O) and is orthogonal to the first straight line (L1), a central portion in a length direction curves in a convex shape toward the other side in the sheet thickness direction,
**characterized in that** a value obtained by dividing a maximum projection amount (Δz) in the sheet thickness direction of the ceramic substrate (40) by a length of the diagonal line of the ceramic substrate (40) is equal to or less than 6 µm/mm.

2. The ceramic substrate (40) according to Claim 1,
wherein, in first parallel cut surfaces, which are parallel to the first cut surface at individual locations extending to both ends of the ceramic substrate (40) in a direction along the first straight line (L1) from the center (O), central portions of the ceramic substrate (40) in the length direction curve in a convex shape toward the one side in the sheet thickness direction, and
in the first parallel cut surfaces at the individual locations, curvatures continuously decrease from the center (O) to both ends of the ceramic substrate (40) in a direction along the second straight line (L2) .

3. The ceramic substrate (40) according to Claim 1 or 2,
wherein, in second parallel cut surfaces, which are parallel to the second cut surface at individual locations extending to both ends of the ceramic substrate (40) in a direction along the second straight line (L2) from the center (O), central portions of the ceramic substrate (40) in the length direction curve in a convex shape toward the other side in the sheet thickness direction, and
in the second parallel cut surfaces at the individual locations, curvatures continuously increase from the center (O) to both ends of the ceramic substrate (40) in a direction along the first straight line (L1).

4. The ceramic substrate (40) according to any one of Claims 1 to 3,
wherein the ceramic substrate (40) has a three-dimensional shape that is linearly symmetrical with respect to the first straight line (L1) as a line of symmetry in the sheet thickness direction.

5. The ceramic substrate (40) according to any one of Claims 1 to 4,
wherein the ceramic substrate (40) has a three-dimensional shape that is linearly symmetrical with respect to the second straight line (L2) as a line of symmetry in the sheet thickness direction.

6. The ceramic substrate (40) according to any one of Claims 1 to 5,
wherein the ceramic substrate (40) contains silicon nitride or aluminum nitride.

7. A composite substrate comprising:
the ceramic substrate (40, 40A) according to any one of Claims 1 to 6;
a first metal layer (50A) fixed to a front surface side (40A1) of the ceramic substrate (40, 40A); and
a second metal layer (50B) fixed to a rear surface side (40A2) of the ceramic substrate (40, 40A).

8. A circuit substrate (60C) comprising:
the ceramic substrate (40, 40A) according to any one of Claims 1 to 6;
a circuit pattern (CP) formed on one surface side (40A1) of the ceramic substrate (40, 40A); and
a metal layer fixed to the other surface side (40A2) of the ceramic substrate (40, 40A).

9. A manufacturing method (S100) of the ceramic substrate (40) according to any one of Claims 1 to 6, comprising:
a strip-shaped green sheet-cutting step (S13) of cutting a strip-shaped green sheet (20) containing a ceramic powder to obtain an individual green sheet (30);
a sintering step (S2) of disposing the individual green sheet (30) in a firing chamber, heating an inside of the firing chamber until a temperature in the firing chamber reaches at least equal to or higher than 1600°C, then, cooling the inside of the firing chamber, and sintering the individual green sheet (30) to obtain the ceramic substrate (40); and
a ceramic substrate-cutting step (S3) of cutting entire peripheral edges of the ceramic substrate (40) cooled after the sintering step (s2),
wherein, the sintering step (S2) comprises a cooling region (F3) in which the temperature in the firing chamber is cooled at a cooling rate of 100 °C/hour or more, the cooling region (F3) including a rapid cooling region (F4) in which the cooling rate is further increased when the temperature in the firing chamber is equal to or higher than 900°C and equal to or lower than 1200°C, and
in the ceramic substrate-cutting step (S3), the entire peripheral edges are cut off at least 3 mm in width.

10. The manufacturing method of the ceramic substrate (40) according to Claim 9,
wherein the ceramic powder contains silicon nitride powder or aluminum nitride powder.

11. A manufacturing method of a composite substrate (60) comprising:
the manufacturing method of the ceramic substrate (40, 40A) according to Claim 9 or 10; and
a fixing step (S5) of fixing a first metal layer (50A) to a front surface side (40A1) of the ceramic substrate (40, 40A) and fixing a second metal layer (50B) to a rear surface side (40A2).

12. A manufacturing method of a circuit substrate (60C) comprising:
the manufacturing method of a composite substrate (60) according to Claim 11; and
a pattern-forming step (S7) of forming at least one circuit pattern (CP) on any one of the first metal layer (50A) and the second metal layer (50B).

13. Amanufacturing method of a plurality of circuit substrates (60C), comprising:
the manufacturing method of a composite substrate (60) according to Claim 11;
a pattern-forming step (S7) of forming a plurality of circuit patterns (CP) on any one of the first metal layer (50A) and the second metal layer (50B); and
a dividing step (S9) of dividing the composite substrate (60) on which the plurality of circuit patterns (CP) have been formed into a plurality of circuit substrates (60C) each having one circuit pattern (CP).

## Patentansprüche

1. Keramiksubstrat (40), das in einer Draufsicht eine rechteckige Form aufweist,
wobei in einer ersten Schnittfläche, die durch den Schnitt einer ersten Geraden (L1) entsteht, die durch einen Mittelpunkt (O) des Keramiksubstrats (40) verläuft und parallel zu einer Seite der vier Seiten in der Draufsicht ist, ein zentraler Abschnitt in einer Längsrichtung in einer konvexen Form in Richtung einer Seite in Plattendickenrichtung gekrümmt ist, und
in einer zweiten Schnittfläche, die durch den Schnitt einer zweiten Geraden (L2) entsteht, die durch den Mittelpunkt (O) verläuft und orthogonal zu der ersten Geraden (L1) steht, ein zentraler Abschnitt in einer Längsrichtung in einer konvexen Form in Richtung der anderen Seite in Plattendickenrichtung gekrümmt ist,
**dadurch gekennzeichnet, dass** ein Wert, der durch Dividieren einer maximalen Projektionsmenge(Δz) in Plattendickenrichtung des Keramiksubstrats (40) durch eine Länge der Diagonale des Keramiksubstrats (40) erhalten wird, kleiner oder gleich 6 pm/mm ist.

2. Keramiksubstrat (40) nach Anspruch 1,
wobei in ersten parallelen Schnittflächen, die an einzelnen Stellen, die sich in einer Richtung entlang der ersten Geraden (L1) von dem Mittelpunkt (O) zu beiden Enden des Keramiksubstrats (40) erstrecken, parallel zu der ersten Schnittfläche sind, zentrale Abschnitte des Keramiksubstrats (40) in der Längsrichtung in einer konvexen Form in Richtung der einen Seite in Plattendickenrichtung gekrümmt sind und
in den ersten parallelen Schnittflächen an den einzelnen Stellen Krümmungen vom Mittelpunkt (O) zu beiden Enden des Keramiksubstrats (40) in einer Richtung entlang der zweiten Geraden (L2) kontinuierlich abnehmen.

3. Keramiksubstrat (40) nach Anspruch 1 oder 2,
wobei in zweiten parallelen Schnittflächen, die an einzelnen Stellen, die sich in einer Richtung entlang der zweiten Geraden (L2) von dem Mittelpunkt (O) zu beiden Enden des Keramiksubstrats (40) erstrecken, parallel zu der zweiten Schnittfläche sind, zentrale Abschnitte des Keramiksubstrats (40) in der Längsrichtung in einer konvexen Form in Richtung der anderen Seite in Plattendickenrichtung gekrümmt sind und
in den zweiten parallelen Schnittflächen an den einzelnen Stellen Krümmungen vom Mittelpunkt (O) zu beiden Enden des Keramiksubstrats (40) in einer Richtung entlang der ersten Geraden (L1) kontinuierlich zunehmen.

4. Keramiksubstrat (40) nach einem der Ansprüche 1 bis 3,
wobei das Keramiksubstrat (40) eine dreidimensionale Form aufweist, die in Bezug auf die erste Gerade (L1) als Symmetrieachse in Plattendickenrichtung linear symmetrisch ist.

5. Keramiksubstrat (40) nach einem der Ansprüche 1 bis 4, wobei das Keramiksubstrat (40) eine dreidimensionale Form aufweist, die in Bezug auf die zweite Gerade (L2) als Symmetrieachse in Plattendickenrichtung linear symmetrisch ist.

6. Keramiksubstrat (40) nach einem der Ansprüche 1 bis 5,
wobei das Keramiksubstrat (40) Siliciumnitrid oder Aluminiumnitrid umfasst.

7. Verbundsubstrat, umfassend:
das Keramiksubstrat (40, 40A) nach einem der Ansprüche 1 bis 6;
eine erste Metallschicht (50A), die an einer vorderen Oberflächenseite (40A1) des Keramiksubstrats (40, 40A) fixiert ist; und
eine zweite Metallschicht (50B), die an einer hinteren Oberflächenseite (40A2) des Keramiksubstrats (40, 40A) fixiert ist.

8. Schaltungssubstrat (60C), umfassend:
das Keramiksubstrat (40, 40A) nach einem der Ansprüche 1 bis 6;
eine Schaltungsstruktur (CP), die auf einer Oberflächenseite (40A1) des Keramiksubstrats (40, 40A) ausgebildet ist; und
eine Metallschicht, die auf der anderen Oberflächenseite (40A2) des Keramiksubstrats (40, 40A) fixiert ist.

9. Herstellungsverfahren (5100) für ein Keramiksubstrat (40) nach einem der Ansprüche 1 bis 6, umfassend:
einen Schritt des Zuschneidens einer bandförmigen Grünlingplatte (S1) zum Zuschneiden einer bandförmigen Grünlingplatte (20), die ein Keramikpulver umfasst, um eine einzelne Grünlingplatte (30) zu erhalten;
einen Sinterschritt (S2) des Platzierens der einzelnen Grünlingplatte (30) in einer Brennkammer, des Erhitzens eines Innenraums der Brennkammer, bis die Temperatur in der Brennkammer zumindest 1600 °C oder mehr erreicht, anschließend des Abkühlens des Innenraums der Brennkammer und des Sinterns der einzelnen Grünlingplatte (30), um das Keramiksubstrat (40) zu erhalten; und
einen Keramiksubstratzuschneideschritt (S3) des Zuschneidens der gesamten Umfangsränder des Keramiksubstrats (40), das nach dem Sinterschritt (S2) abgekühlt ist,
wobei der Sinterschritt (S2) einen Abkühlbereich (F3) umfasst, in dem die Temperatur in der Brennkammer mit einer Abkühlrate von 100 °C/h oder mehr abgekühlt wird, wobei der Abkühlbereich (F3) einen Schnellabkühlbereich (F4) umfasst, in dem die Abkühlrate weiter gesteigert wird, wenn die Temperatur in der Brennkammer 900 °C oder mehr und 1200 °C oder weniger beträgt, und
in dem Keramiksubstratzuschneideschritt (S3) die gesamten Umfangsränder in einer Breite von zumindest 3 mm abgeschnitten werden.

10. Herstellungsverfahren für ein Keramiksubstrat (40) nach Anspruch 9,
wobei das Keramikpulver Siliciumnitridpulver oder Aluminiumnitridpulver umfasst.

11. Herstellungsverfahren für ein Verbundsubstrat (60), umfassend:
das Herstellungsverfahren für ein Keramiksubstrat (40, 40A) nach Anspruch 9 oder 10; und
einen Fixierschritt (S5) des Fixierens der ersten Metallschicht (50A) an einer vorderen Oberflächenseite (40A1) des Keramiksubstrats (40, 40A) und des Fixierens einer zweiten Metallschicht (50B) auf einer hinteren Oberflächenseite (40A2) .

12. Herstellungsverfahren für ein Schaltungssubstrat (60C), umfassend:
das Herstellungsverfahren für ein Verbundsubstrat (60) nach Anspruch 11; und
einen Strukturbildungsschritt (S7) des Ausbildens zumindest einer Schaltungsstruktur (CP) auf einer beliebigen von der ersten Metallschicht (50A) und der zweiten Metallschicht (50B).

13. Herstellungsverfahren für eine Mehrzahl von Schaltungssubstraten (60C), umfassend:
das Herstellungsverfahren für ein Verbundsubstrat (60) nach Anspruch 11;
einen Strukturbildungsschritt (S7) des Ausbildens zumindest einer Schaltungsstruktur (CP) auf einer beliebigen von der ersten Metallschicht (50A) und der zweiten Metallschicht (50B); und
einen Aufteilschritt (S9) des Aufteilens des Verbundsubstrats (60), auf dem die Mehrzahl von Schaltungsstrukturen (CP) ausgebildet wurde, in eine Mehrzahl von Schaltungssubstraten (60C), die jeweils eine Schaltungsstruktur (CP) aufweisen.

## Revendications

1. Substrat céramique (40) ayant une forme rectangulaire dans une vue en plan,
dans lequel, dans une première surface de coupe coupée par une première ligne droite (L1) qui passe par un centre (O) du substrat céramique (40) et est parallèle à un côté quelconque parmi quatre côtés dans la vue en plan, une partie centrale dans une direction de la longueur s'incurve selon une forme convexe vers un côté dans une direction de l'épaisseur de la feuille, et
dans une deuxième surface de coupe coupée par une deuxième ligne droite (L2) qui passe par le centre (O) et est orthogonale à la première ligne droite (L1), une partie centrale dans une direction de la longueur s'incurve selon une forme convexe vers l'autre côté dans la direction de l'épaisseur de la feuille,
**caractérisé en ce qu'**une valeur obtenue en divisant une quantité de projection maximale (Δz) dans la direction de l'épaisseur de la feuille du substrat céramique (40) par une longueur de la ligne diagonale du substrat céramique (40) est égale ou inférieure à 6 pm/mm.

2. Substrat céramique (40) selon la revendication 1,
dans lequel, dans des premières surfaces de coupe parallèles, qui sont parallèles à la première surface de coupe à des emplacements individuels s'étendant aux deux extrémités du substrat céramique (40) dans une direction le long de la première ligne droite (L1) à partir du centre (O), des parties centrales du substrat céramique (40) dans la direction de la longueur s'incurvent selon une forme convexe vers un côté dans la direction de l'épaisseur de la feuille, et
dans les premières surfaces de coupe parallèles aux emplacements individuels, les courbures diminuent continuellement du centre (O) aux deux extrémités du substrat céramique (40) dans une direction le long de la deuxième ligne droite (L2).

3. Substrat céramique (40) selon la revendication 1 ou 2,
dans lequel, dans des deuxièmes surfaces de coupe parallèles, qui sont parallèles à la deuxième surface de coupe à des emplacements individuels s'étendant aux deux extrémités du substrat céramique (40) dans une direction le long de la deuxième ligne droite (L2) à partir du centre (O), des parties centrales du substrat céramique (40) dans la direction de la longueur s'incurvent selon une forme convexe vers l'autre côté dans la direction de l'épaisseur de la feuille, et
dans les deuxièmes surfaces de coupe parallèles aux emplacements individuels, les courbures augmentent continuellement du centre (O) aux deux extrémités du substrat céramique (40) dans une direction le long de la première ligne droite (L1).

4. Substrat céramique (40) selon l'une quelconque des revendications 1 à 3,
dans lequel le substrat céramique (40) a une forme tridimensionnelle qui est linéairement symétrique par rapport à la première ligne droite (L1) en tant que ligne de symétrie dans la direction de l'épaisseur de la feuille.

5. Substrat céramique (40) selon l'une quelconque des revendications 1 à 4,
dans lequel le substrat céramique (40) a une forme tridimensionnelle qui est linéairement symétrique par rapport à la deuxième ligne droite (L2) en tant que ligne de symétrie dans la direction de l'épaisseur de la feuille.

6. Substrat céramique (40) selon l'une quelconque des revendications 1 à 5,
dans lequel le substrat céramique (40) contient du nitrure de silicium ou du nitrure d'aluminium.

7. Substrat composite, comprenant :
le substrat céramique (40, 40A) selon l'une quelconque des revendications 1 à 6 ;
une première couche métallique (50A) fixée sur un côté de surface avant (40A1) du substrat céramique (40, 40A) ; et
une deuxième couche métallique (50B) fixée sur un côté de surface arrière (40A2) du substrat céramique (40, 40A).

8. Substrat de circuit (60C), comprenant :
le substrat céramique (40, 40A) selon l'une quelconque des revendications 1 à 6 ;
un motif de circuit (CP) formé sur un côté de surface (40A1) du substrat céramique (40, 40A) ; et
une couche métallique fixée sur l'autre côté de surface (40A2) du substrat céramique (40, 40A).

9. Procédé de fabrication (S100) du substrat céramique (40) selon l'une quelconque des revendications 1 à 6, comprenant :
une étape de coupe de feuille verte en forme de bande (S13) consistant à couper une feuille verte en forme de bande (20) contenant une poudre céramique pour obtenir une feuille verte individuelle (30) ;
une étape de frittage (S2) consistant à disposer la feuille verte individuelle (30) dans une chambre de cuisson, à chauffer un intérieur de la chambre de cuisson jusqu'à ce qu'une température dans la chambre de cuisson atteigne au moins une valeur égale ou supérieure à 1 600 °C, puis à refroidir l'intérieur de la chambre de cuisson et à fritter la feuille verte individuelle (30) afin d'obtenir le substrat céramique (40) ; et
une étape de coupe de substrat céramique (S3) consistant à couper les bords périphériques entiers du substrat céramique (40) refroidi après l'étape de frittage (s2),
dans lequel l'étape de frittage (S2) comprend une région de refroidissement (F3) dans laquelle la température dans la chambre de cuisson est refroidie à une vitesse de refroidissement de 100 °C/heure ou plus, la région de refroidissement (F3) incluant une région de refroidissement rapide (F4) dans laquelle la vitesse de refroidissement est encore augmentée lorsque la température dans la chambre de cuisson est égale ou supérieure à 900 °C et égale ou inférieure à 1 200 °C, et
lors de l'étape de coupe de substrat céramique (S3), les bords périphériques entiers sont coupés sur une largeur d'au moins 3 mm.

10. Procédé de fabrication du substrat céramique (40) selon la revendication 9,
dans lequel la poudre céramique contient de la poudre de nitrure de silicium ou de la poudre de nitrure d'aluminium.

11. Procédé de fabrication d'un substrat composite (60), comprenant :
le procédé de fabrication du substrat céramique (40, 40A) selon la revendication 9 ou 10 ; et
une étape de fixation (S5) consistant à fixer une première couche métallique (50A) sur un côté de surface avant (40A1) du substrat céramique (40, 40A) et à fixer une deuxième couche métallique (50B) sur un côté de surface arrière (40A2).

12. Procédé de fabrication d'un substrat de circuit (60C), comprenant :
le procédé de fabrication d'un substrat composite (60) selon la revendication 11 ; et
une étape de formation de motif (S7) consistant à former au moins un motif de circuit (CP) sur l'une quelconque parmi la première couche métallique (50A) et la deuxième couche métallique (50B).

13. Procédé de fabrication d'une pluralité de substrats de circuit (60C), comprenant :
le procédé de fabrication d'un substrat composite (60) selon la revendication 11 ;
une étape de formation de motifs (S7) consistant à former une pluralité de motifs de circuit (CP) sur l'une quelconque parmi la première couche métallique (50A) et la deuxième couche métallique (50B) ; et
une étape de division (S9) consistant à diviser le substrat composite (60) sur lequel la pluralité de motifs de circuit (CP) a été formée en une pluralité de substrats de circuit (60C) ayant chacun un motif de circuit (CP).
